(19) Europäisches Patentamt / European Patent Office / Office européen des brevets

(11) **EP 3 589 964 B1**

(12) **EUROPÄISCHE PATENTSCHRIFT**

(45) Veröffentlichungstag und Bekanntmachung des Hinweises auf die Patenterteilung:
**25.01.2023 Patentblatt 2023/04**

(21) Anmeldenummer: **18708621.0**

(22) Anmeldetag: **22.02.2018**

(51) Internationale Patentklassifikation (IPC):
**G01R 31/12** (2020.01)    **G01R 27/26** (2006.01)
**G01R 31/64** (2020.01)    G01R 31/62 (2020.01)
**G01R 15/06** (2006.01)

(52) Gemeinsame Patentklassifikation (CPC):
**G01R 27/2694; G01R 31/1245; G01R 31/64;**
G01R 15/06; G01R 31/62

(86) Internationale Anmeldenummer:
**PCT/EP2018/054398**

(87) Internationale Veröffentlichungsnummer:
**WO 2018/158135 (07.09.2018 Gazette 2018/36)**

(54) **VERFAHREN UND VORRICHTUNG ZUR VERLUSTFAKTORÜBERWACHUNG VON KONDENSATORDURCHFÜHRUNGEN**

METHOD AND APPARATUS FOR MONITORING THE LOSS FACTOR OF CAPACITOR BUSHINGS

PROCÉDÉ ET DISPOSITIF POUR SURVEILLER LES FACTEURS DE PERTES DE TRAVERSÉES DE CONDENSATEURS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.02.2017 DE 102017104110**

(43) Veröffentlichungstag der Anmeldung:
**08.01.2020 Patentblatt 2020/02**

(73) Patentinhaber: **Maschinenfabrik Reinhausen GmbH**
**93059 Regensburg (DE)**

(72) Erfinder:
- **VIERECK, Karsten**
  **93049 Regensburg (DE)**
- **WU, Junliang**
  **93055 Regensburg (DE)**
- **SUNDERMANN, Ulrich**
  **44149 Dortmund (DE)**

(56) Entgegenhaltungen:
EP-A1- 3 070 483    EP-A2- 0 747 715
WO-A1-2015/071253    CN-A- 104 122 490

- XIA JIUYUN ET AL: "Research of on-line monitoring method for insulation condition of power transformer bushing", BIOMEDICAL PHOTONICS AND OPTOELECTRONIC IMAGING : 8 - 10 NOVEMBER 2000, BEIJING, CHINA; [PROCEEDINGS // SPIE, INTERNATIONAL SOCIETY FOR OPTICAL ENGINEERING : P, ISSN 0038-7355], SPIE, BELLINGHAM, WASH., US, Bd. 9903, 26. Januar 2016 (2016-01-26), Seiten 99031T-99031T, XP060063504, DOI: 10.1117/12.2214134 ISBN: 978-1-62841-832-3
- MAIK KOCH ET AL: "A new method for on-line monitoring of bushings and partial discharges of power transformers", CONDITION MONITORING AND DIAGNOSIS (CMD), 2012 INTERNATIONAL CONFERENCE ON, IEEE, 23. September 2012 (2012-09-23), Seiten 1205-1208, XP032312763, DOI: 10.1109/CMD.2012.6416378 ISBN: 978-1-4673-1019-2

**Beschreibung**

Die Erfindung betrifft ein Verfahren und eine Vorrichtung zur Überwachung von Kondensatordurchführungen für ein dreiphasiges Wechselstromnetz.

Elektrische Geräte für Wechselstromnetze, wie beispielsweise Leistungstransformatoren und Drosseln, sind üblicherweise mithilfe von Kondensatordurchführungen an die Netzleitungen des Wechselstromnetzes angeschlossen. Da ein Versagen oder Ausfall dieser Kondensatordurchführungen mit schwerwiegenden Folgen, wie z.B. Beschädigung oder Zerstörung der elektrischen Geräte und daraus resultierenden Ausfällen der Energieversorgung, verbunden sein kann, ist es bekannt, relevante Kenngrößen der Kondensatordurchführungen, wie z.B. Kapazitäten und Verlustfaktoren im Betrieb, zu überwachen. Bei den bekannten Verfahren zur Verlustfaktorüberwachung können sich verschiede Einflussfaktoren, wie z.B. die an den Kondensatordurchführungen anliegende Hochspannung oder Temperaturschwankungen im Betrieb deutlich auf die erfassten Kennwerte auswirken und so eine zuverlässige Überwachung erschweren.

DE 10 2004 027 349 A1 beschreibt ein Verfahren zum Ermitteln des Verlustfaktors einer Isolierung einer Hochspannungsdurchführung. Die Hochspannungsdurchführung verfügt über Einlagen zur Absteuerung eines elektrischen Feldes, wobei eine Außenklemme auf dem Potential einer ersten Einlage und wenigstens eine Innenklemme vorgesehen sind, die mit einer bezüglich der ersten Einlage im Querschnitt weiter innen angeordneten Einlage verbunden ist. Weiterhin wird die Außenklemme über einen regelbaren Referenzkondensator mit Erdpotential verbunden. Eine zwischen Innenklemme und Außenklemme abfallende Prüfspannung, eine an einem Referenzkondensator abfallende Stellspannung und eine Phasenverschiebung zwischen der Prüfspannung und der Stellspannung werden ermittelt. Durch Bilden der Differenz zwischen Prüfspannung und Stellspannung unter Berücksichtigung der Phasenverschiebung wird eine resultierende Spannung berechnet. Nun wird der Referenzkondensator so geregelt, dass eine Phasenverschiebung zwischen der resultierenden Spannung und der Prüfspannung oder zwischen der resultierenden Spannung der Stellspannung gleich Null ist. Die Einstellungen des Referenzkondensators können somit als Hinweis auf den Alterungszustand oder die Güte der Isolierung gewertet werden.

DE 100 37 432 A1 beschreibt ein Verfahren zur Überwachung einer mit einer elektrischen Betriebsspannung beaufschlagten Kondensatordurchführung, bei der mit einer elektrisch leitenden Einlage ein Spannungsteiler gebildet ist, wobei mit einem mit der Einlage verbundenen Messabgriff und mit Erdpotential mindestens ein Messwert einer elektrischen Messgröße erfasst und gespeichert wird. Nach Erfassung des mindestens einen Messwerts wird die Impedanz zwischen dem Messabgriff und dem Erdpotential verändert und mit dem Messabgriff und dem Erdpotential mindestens ein Signalwert eines sich dann bildenden Messsignals erfasst und gespeichert, wobei der zeitliche Abstand zwischen dem Zeitpunkt der Erfassung des einen Messwerts und dem Zeitpunkt der Erfassung eines Signalwerts derart bemessen ist, dass eine gegebenenfalls zwischen den beiden Zeitpunkten erfolgte Änderung der Betriebsspannung vernachlässigbar ist.

WO 2015/071253 A1 beschreibt ein Verfahren zur Überwachung von Kondensatordurchführungen eines dreiphasigen Wechselstromnetzes, wobei die Ober- und Istkapazitäten jeder einzelnen Kondensatordurchführung ermittelt und überwacht werden.

Vor diesem Hintergrund schlägt die Erfindung die Gegenstände der unabhängigen Ansprüche vor. Vorteilhafte Weiterbildungen sind in den Unteransprüchen beschrieben.

Die Erfindung ermöglicht eine bessere Überwachung der Kondensatordurchführungen. Die Erfindung schlägt gemäß einem ersten Aspekt ein Verfahren zum Überwachen von Kondensatordurchführungen für ein Wechselstromnetz gemäß Anspruch 1 vor.

Das vorgeschlagene Verfahren nutzt die Kenn- und Messgrößen benachbarter Kondensatordurchführungen desselben Leistungstransformators für die eigentliche Überwachung. Hierbei werden die externen Einflüsse, wie z.B. Temperaturänderungen, auf die Verlustfaktoränderungen der Kondensatordurchführung ausgeglichen. Darüber hinaus wird vermieden, dass beim Überwachen einer Kondensatordurchführung, die ja an die ihr zugeordnete Netzleitung angeschlossen ist, Schwankungen der an einer Netzleitung anliegenden Netzspannung, über die an die jeweilige Netzleitung angeschlossene Kondensatordurchführung auf die Messspannung übertragen werden. So können Messtoleranzen beim Erfassen der Belagspannungen zumindest teilweise kompensiert werden und eine bessere Aussage über den Zustand der Kondensatordurchführung getroffen werden.

Der Verlustfaktor für jede Kondensatordurchführung wird gemäß Anspruch 1 bestimmt. Üblicherweise liegen die Verlustfaktoren für Kondensatordurchführungen im Hochspannungsbereich dabei im Bereich zwischen 0, 005%, und 1%.

Jede Kondensatordurchführung kann nach Bedarf auf beliebige Art und Weise ausgebildet sein und beispielsweise über eine Ober- und eine Unterkapazität verfügen. Die Oberkapazität kann beispielsweise als die Kapazität eines Kondensators, der von dem jeweiligen Belag und dem jeweiligen Leiter gebildet wird, ausgebildet sein. Übliche Werte für Oberkapazitäten liegen im Bereich zwischen 200 und 600pF.

Die Unterkapazität kann beispielsweise als die Kapazität einer Parallelschaltung, die eine Messeinrichtung, mit der beispielsweise eine Belagspannung erfasst und/oder gemessen werden kann, und einen Kondensator umfasst, gebildet werden. Der vorgenannte Kondensator wird dabei von dem jeweiligen äußersten Belag und Massepotential oder von dem jeweiligen äußersten Belag und einem elektrisch leitfähigen Flansch, der an der Außenfläche der jeweiligen Kondensatordurchführung befestigt ist und an Massepotenzial anliegt, gebildet. Üblicherweise liegen die Unterkapazitäten zwischen 1 und 5 μF, sie können aber auch nach Bedarf andere Werte haben und beispielsweise zwischen 0,1 μF und 50 μF oder zwischen 0,2 μF und 20 μF oder zwischen 0,5 μF und 10 μF liegen.

Als Netzspannung wird im Folgenden die Spannung bezeichnet, die zwischen einer Phase des Wechselstromnetzes und Massepotential anliegt. Die Messung der Netzspannung sowie Bildung der Netzspannungszeiger kann auf beliebige Art und Weise, beispielsweise mittels kapazitiver Spannungsteiler, erfolgen.

Als Belagspannung wird im Folgenden die an der Unterkapazität mittels einer Messeinrichtung erfasste Spannung, die zwischen dem äußersten Belag der Kondensatordurchführung und Massepotential anliegt, bezeichnet. Die Ermittlung des Belagspannungszeigers/komplexen Belagspannungswerts erfolgt mittels bekannter Verfahren der Elektrotechnik.

Bei einem dreiphasigen Wechselstromnetz ist der Begriff »benachbart« in Hinblick auf einen vorbestimmten Drehsinn des entsprechenden Zeigersystems definiert, beispielsweise derart, dass die zweite Phase B der ersten Phase A benachbart ist, die dritte Phase C der zweiten Phase B und die erste Phase A der dritten Phase C.

Der Toleranzwert kann nach Bedarf auf beliebige Art und Weise ausgebildet sein und beispielsweise einen prozentualen Anteil einer entsprechenden Kenngröße aus dem Datenblatt einer Kondensatordurchführung darstellen oder basierend auf Erfahrungswerten abgeleitet werden. Die Toleranzwerte können bei Bedarf für alle Kondensatordurchführungen einheitlich oder individuell für jede Kondensatordurchführung unterschiedlich gewählt werden.

Das Überwachungssignal kann nach Bedarf auf beliebige Art und Weise ausgebildet sein, beispielsweise als akustisches und/oder optisches und/oder elektrisches Signal.

Es kann vorgesehen sein, dass jede Referenzspannung die jeweilige Netzspannung ist.

Es kann vorgesehen sein, dass

- der ersten Netzleitung eine erste Parallel-Kondensatordurchführung zugeordnet ist;
- der zweiten Netzleitung eine zweite Parallel-Kondensatordurchführung zugeordnet ist;
- der dritten Netzleitung eine dritte Parallel-Kondensatordurchführung zugeordnet ist;
- jede dieser Parallel-Kondensatordurchführungen dabei einen Leiter, der mit der zugeordneten Netzleitung verbunden ist und einen elektrisch leitfähigen Belag der diesen Leiter umgibt, umfasst;
- für jede dieser Phasen die erste und zweite Referenzspannung eine erste und zweite Belagspannung ist, die jeweils zum ersten Zeitpunkt und zum zweiten Zeitpunkt zwischen dem Belag und Massepotenzial der jeweiligen Parallel-Kondensatordurchführung anliegt.

Diese Parallel-Kondensatordurchführungen sind beispielsweise vorhanden, um zusätzlich zu einem ersten elektrischen Gerät, das über die drei Kondensatordurchführungen an die drei Phasen angeschlossen ist, ein zweites elektrisches Gerät, das hier auch als Parallel-Gerät bezeichnet wird, parallel zu dem ersten Gerät an die drei Phasen anzuschließen. Da die Parallel-Belagspannungswerte die anfänglichen Referenzspannungswerte bilden, kann auf die Erfassung der Netzspannungen verzichtet werden. Dies führt, ohne die Genauigkeit des Überwachungsverfahrens negativ zu beeinflussen, zu Kosteneinsparungen sowie erleichterter Wartung und Instandhaltung, da weniger Messgeräte eingesetzt werden müssen.

Es kann vorgesehen sein, dass für jede der Phasen die Referenzspannung eine Konstantspannung ist, für die ein entsprechender Konstantspannungszeiger vorbestimmt ist. Es kann vorgesehen sein, dass die Größe jedes Konstantspannungszeigers gleich einem Nennspannungswert des Wechselstromnetzes ist und für die erste Phase der Phasenwinkel des ersten und zweiten Konstantspannungszeigers 0° beträgt, für die zweite Phase der Phasenwinkel des ersten und zweiten Konstantspannungszeigers 120° beträgt und für die dritte Phase der Phasenwinkel des ersten und zweiten Konstantspannungszeigers 240° beträgt.

Es ist vorgesehen, dass

- die Verlustfaktoränderung der ersten Kondensatordurchführung gemäß folgender Formel

$$\Delta D_a(t_2) = \theta_{ab}(t_2) - \theta_{ab}(t_1)$$

mit

$$\theta_{ab}(t_j) = \left( \arccos \frac{\underline{V}_a(t_j) \cdot \underline{V}_b(t_j)}{\left|\underline{V}_a(t_j)\right| \cdot \left|\underline{V}_b(t_j)\right|} - \arccos \frac{\underline{R}_a(t_j) \cdot \underline{R}_b(t_j)}{\left|\underline{R}_a(t_j)\right| \cdot \left|\underline{R}_b(t_j)\right|} \right), j = 1, 2$$

berechnet wird; und/oder
- die Verlustfaktoränderung der zweiten Kondensatordurchführung gemäß folgender Formel

$$\Delta D_b(t_2) = \theta_{bc}(t_2) - \theta_{bc}(t_1)$$

mit

$$\theta_{bc}(t_j) = \left( \arccos \frac{\underline{V}_b(t_j) \cdot \underline{V}_c(t_j)}{\left|\underline{V}_b(t_j)\right| \cdot \left|\underline{V}_c(t_j)\right|} - \arccos \frac{\underline{R}_b(t_j) \cdot \underline{R}_c(t_j)}{\left|\underline{R}_b(t_j)\right| \cdot \left|\underline{R}_c(t_j)\right|} \right), j = 1, 2$$

berechnet wird; und/oder
- die Verlustfaktoränderung der dritten Kondensatordurchführung gemäß folgender Formel

$$\Delta D_c(t_2) = \theta_{ca}(t_2) - \theta_{ca}(t_1)$$

mit

$$\theta_{ca}(t_j) = \left( \arccos \frac{\underline{V}_c(t_j) \cdot \underline{V}_a(t_j)}{\left|\underline{V}_c(t_j)\right| \cdot \left|\underline{V}_a(t_j)\right|} - \arccos \frac{\underline{R}_c(t_j) \cdot \underline{R}_a(t_j)}{\left|\underline{R}_c(t_j)\right| \cdot \left|\underline{R}_a(t_j)\right|} \right), j = 1, 2$$

berechnet wird;
- wobei Ra(t1), Rb(t1), Rc(t1) die ersten Referenzspannungszeiger der ersten, zweiten und dritten Phase sind;
- und Va(t1), Vb(t1), Vc(t1) die ersten Belagspannungszeiger der ersten, zweiten und dritten Phase sind;
- und Ra(t2), Rb(t2), Rc(t2) die zweiten Referenzspannungszeiger der ersten, zweiten und dritten Phase sind;
- und Va(t2), Vb(t2), Vc(t2) die zweiten Belagspannungszeiger der ersten, zweiten und dritten Phase sind.

Es kann vorgesehen sein, dass Toleranzwerte DA > 0, DB > 0, DC > 0 für die Verlustfaktorvergleiche bestimmt werden und falls die Verlustfaktorvergleiche ergeben, dass

$$\left|\Delta D_a(t_2)\right| \leq D_A \text{ und } \left|\Delta D_b(t_2)\right| \leq D_B \text{ und } \left|\Delta D_c(t_2)\right| \leq D_C$$

gilt, dann ein Überwachungssignal erzeugt wird, das anzeigt, dass die Kondensatordurchführungen in ordnungsgemäßem Zustand sind und andernfalls ein Überwachungssignal erzeugt wird, das anzeigt, dass zumindest eine Kondensatordurchführung nicht in ordnungsgemäßem Zustand ist.

Es kann vorgesehen sein, dass Toleranzwerte DA > 0, DB > 0, DC > 0 für die Verlustfaktorvergleiche bestimmt werden und

- falls die Verlustfaktorvergleiche ergeben, dass

$$\left|\Delta D_a(t_2)\right| > D_A \text{ und } \left|\Delta D_b(t_2)\right| > D_B \text{ und } \left|\Delta D_c(t_2)\right| \leq D_C$$

gilt, dann ein Überwachungssignal erzeugt wird, das anzeigt, dass entweder die zweite Kondensatordurchführung nicht in ordnungsgemäßem Zustand ist oder die beiden anderen Kondensatordurchführungen nicht in ordnungsgemäßem Zustand sind und einen gleichartigen Fehler haben;

- falls die Verlustfaktorvergleiche ergeben, dass

$$\left|\Delta D_a(t_2)\right| \le D_A \text{ und } \left|\Delta D_b(t_2)\right| > D_B \text{ und } \left|\Delta D_c(t_2)\right| > D_C$$

gilt, dann ein Überwachungssignal erzeugt wird, das anzeigt, dass entweder die dritte Kondensatordurchführung nicht in ordnungsgemäßem Zustand ist oder die beiden anderen Kondensatordurchführungen nicht in ordnungsgemäßem Zustand sind und einen gleichartigen Fehler haben;

- falls die Verlustfaktorvergleiche ergeben, dass

$$\left|\Delta D_a(t_2)\right| > D_A \text{ und } \left|\Delta D_b(t_2)\right| \le D_B \text{ und } \left|\Delta D_c(t_2)\right| > D_C$$

gilt, dann ein Überwachungssignal erzeugt wird, das anzeigt, dass entweder die erste Kondensatordurchführung nicht in ordnungsgemäßem Zustand ist oder die beiden anderen Kondensatordurchführungen nicht in ordnungsgemäßem Zustand sind und einen gleichartigen Fehler haben.

Jeder dieser Toleranzwerte DA, DB, DC kann nach Bedarf auf beliebige Art und Weise bestimmt werden und beispielsweise auf einen Wert von 0,0001, oder 0,0002, oder 0,0005, oder 0,001, oder 0,002, oder 0,005, oder 0,01 oder 0,02, oder 0,05 gesetzt werden. Jeder dieser Toleranzwerte und wenigstens einer der anderen Toleranzwerte können gleich oder ungleich sein.

Es kann vorgesehen sein, dass andernfalls ein Überwachungssignal erzeugt wird, das anzeigt, dass entweder alle drei Kondensatordurchführungen nicht in ordnungsgemäßem Zustand sind oder zwei Kondensatordurchführungen nicht in ordnungsgemäßem Zustand sind und keinen gleichartigen Fehler haben.

Es kann vorgesehen sein, dass jeder Toleranzwert vom Alter der jeweiligen Kondensatordurchführung antiton abhängt.

Es kann weiterhin vorgesehen sein, dass zu einem vorbestimmten dritten Zeitpunkt, der nach dem zweiten Zeitpunkt liegt, für jede dieser Phasen

- für eine Referenzspannung und ein entsprechender dritter Referenzspannungszeiger oder komplexer Referenzspannungswert ermittelt wird;
- die Belagspannung erfasst und ein entsprechender dritter Belagspannungszeiger oder komplexer Belagspannungswert ermittelt wird;
- der zweite Referenzspannungszeiger durch den dritten Referenzspannungszeiger und der zweite Belagspannungszeiger durch den dritten Belagspannungszeiger ersetzt wird;

  - für jede dieser Kondensatordurchführungen

- das Berechnen und Vergleichen der Verlustfaktoränderung wiederholt wird;

  - ein Überwachungssignal in Abhängigkeit von den Ergebnissen dieser Verlustfaktorvergleiche erzeugt wird.

Es kann weiterhin vorgesehen sein, dass vor jedem Ersetzen des zweiten Referenzspannungszeigers und Belagspannungszeigers der erste Referenzspannungszeiger durch den zweiten Referenzspannungszeiger und der erste Belagspannungszeiger durch den zweiten Belagspannungszeiger ersetzt wird.

Es kann weiterhin vorgesehen sein, dass zu wenigstens einem vorbestimmten späteren Zeitpunkt, der nach dem zweiten Zeitpunkt liegt, für jede dieser Phasen

- für eine Referenzspannung ein entsprechender späterer Referenzspannungszeiger oder komplexer Netzspannungswert ermittelt wird;
- die Belagspannung erfasst und ein entsprechender späterer Belagspannungszeiger oder komplexer Belagspannungswert ermittelt wird;
- für jede dieser Kondensatordurchführungen das Berechnen der Verlustfaktoränderung zusätzlich von den jeweiligen späteren Referenzspannungszeigern und Belagspannungszeigern abhängt.

Es kann weiterhin vorgesehen sein, dass zu wenigstens einem vorbestimmten späteren Zeitpunkt, der nach dem zweiten Zeitpunkt liegt, für jede dieser Phasen

- für eine Referenzspannung ein entsprechender späterer Referenzspannungszeiger oder komplexer Referenzspannungswert ermittelt wird;
- die Belagspannung erfasst und ein entsprechender späterer Belagspannungszeiger oder komplexer Belagspannungswert ermittelt wird;

  - für jede dieser Kondensatordurchführungen

- eine Verlustfaktoränderung in Abhängigkeit von den jeweiligen ersten, zweiten und späteren Referenzspannungszeigern und Belagspannungszeigern sowie von den ersten, zweiten und späteren Referenzspannungszeigern und Belagspannungszeigern der jeweils benachbarten Kondensatordurchführung berechnet wird;
- die Verlustfaktoränderung mit einem Toleranzwert verglichen wird;

  - ein Überwachungssignal in Abhängigkeit von den Ergebnissen dieser Verlustfaktorvergleiche erzeugt wird.

Es kann weiterhin vorgesehen sein, dass die Verlustfaktoränderung der ersten Kondensatordurchführung gemäß folgender Formel

$$\Delta D_a(t_n) = \sum_{i=2}^{n} \left\{ g_{ai}[\theta_{ab}(t_i) - \theta_{ab}(t_{i-1})] \right\}$$

mit

$$\theta_{ab}(t_j) = \arccos\frac{\underline{V}_a(t_j)\cdot\underline{V}_b(t_j)}{\left|\underline{V}_a(t_j)\right|\cdot\left|\underline{V}_b(t_j)\right|} - \arccos\frac{\underline{R}_a(t_j)\cdot\underline{R}_b(t_j)}{\left|\underline{R}_a(t_j)\right|\cdot\left|\underline{R}_b(t_j)\right|} \quad ,j = 1, \ldots, n$$

$$\sum_{i=2}^{n} g_{ai} = 1$$

berechnet wird; und/oder

- die Verlustfaktoränderung der zweiten Kondensatordurchführung gemäß folgender Formel

$$\Delta D_b(t_n) = \sum_{i=2}^{n} \left\{ g_{bi}[\theta_{bc}(t_i) - \theta_{bc}(t_{i-1})] \right\}$$

mit

$$\theta_{bc}(t_j) = \arccos\frac{\underline{V}_b(t_j)\cdot\underline{V}_c(t_j)}{\left|\underline{V}_b(t_j)\right|\cdot\left|\underline{V}_c(t_j)\right|} - \arccos\frac{\underline{R}_b(t_j)\cdot\underline{R}_c(t_j)}{\left|\underline{R}_b(t_j)\right|\cdot\left|\underline{R}_c(t_j)\right|} \quad ,j = 1, \ldots, n$$

$$\sum_{i=2}^{n} g_{bi} = 1$$

berechnet wird; und/oder

- die Verlustfaktoränderung der dritten Kondensatordurchführung gemäß folgender Formel

$$\Delta D_C(t_n) = \sum_{i=2}^{n} \left\{ g_{ci} [\theta_{ca}(t_i) - \theta_{ca}(t_{i-1})] \right\}$$

mit

$$\theta_{ca}(t_j) = \arccos \frac{\underline{V}_c(t_j) \cdot \underline{V}_a(t_j)}{\left|\underline{V}_c(t_j)\right| \cdot \left|\underline{V}_a(t_j)\right|} - \arccos \frac{\underline{R}_c(t_j) \cdot \underline{R}_a(t_j)}{\left|\underline{R}_c(t_j)\right| \cdot \left|\underline{R}_a(t_j)\right|} \quad , j = 1, ..., n$$

$$\sum_{i=2}^{n} g_{ci} = 1$$

berechnet wird; wobei
- n > 2 die Anzahl der Zeitpunkte ist;
- t1, t2 der erste und zweite Zeitpunkt und t3, ..., tn die späteren Zeitpunkte sind;
- gai, gbi, gci i-te Gewichtungsfaktoren für die erste, zweite und dritte Kondensatordurchführung sind.

Es kann weiterhin vorgesehen sein, dass jeder Gewichtungsfaktor vom Alter des jeweiligen Zeitpunkts antiton abhängt; und/oder für die Gewichtungsfaktoren

$$g_{ai-1} \leq g_{ai} \text{ und/oder } g_{bi-1} \leq g_{bi} \text{ und/oder } g_{ci-1} \leq g_{ci} \text{ für i = 2, ..., n}$$

gilt.
Es kann weiterhin vorgesehen sein, dass

- zwischen dem Ermitteln der ersten Referenzspannungszeiger und dem Ermitteln der ersten Belagspannungszeiger

    • die Größen der ersten Referenzspannungszeiger untereinander verglichen werden,
    • das Ermitteln der ersten Belagspannungszeiger erfolgt, falls diese Größenvergleiche ergeben, dass diese Größen nicht mehr als ein vorbestimmtes Maß voneinander abweichen;

und/oder
- zwischen dem Ermitteln der zweiten Referenzspannungszeiger und dem Ermitteln der zweiten Belagspannungszeiger

    • die Größen der zweiten Referenzspannungszeiger untereinander verglichen werden,
    • das Ermitteln der zweiten Belagspannungszeiger erfolgt, falls diese Größenvergleiche ergeben, dass diese Größen nicht mehr als ein vorbestimmtes Maß voneinander abweichen.

Dieses Vergleichen der Größen der Referenzspannungszeiger ermöglicht, dass ein Zeitpunkt bestimmt wird, zu dem die eigentliche Überwachung, nämlich der Vergleich der Verlustfaktoränderungen der Kondensatordurchführungen und das Erzeugen des Überwachungssignals, besonders vorteilhaft oder günstig ist, da sie dann nicht durch über das vorbestimmte Maß hinaus voneinander abweichende Referenzspannungen erschwert, behindert oder gar unmöglich gemacht wird. Damit wird erreicht, dass unabhängig von Schwankungen der Spannungen im Wechselstromnetz sowie von Messtoleranzen beim Erfassen der Belagspannungen eine bessere Aussage über den Zustand der Kondensatordurchführungen getroffen werden kann.
Durch die Berücksichtigung der Referenzspannungen können beispielsweise zeitliche Änderungen der Spannungsverhältnisse, die auch als Asymmetrien bezeichnet werden, erfasst werden und somit die entsprechenden Abweichungen der an den Kondensatordurchführungen abgegriffenen Belagspannungen zumindest teilweise kompensiert werden. Damit wird eine zuverlässige Überwachung der Kondensatordurchführungen unter Berücksichtigung und Bewertung der Abweichungen und der Störungen der Spannungen im Wechselstromnetz gewährleistet.

Zum Vergleich der Größen der Referenzspannungszeiger können je nach Bedarf Beträge und/oder Effektivwerte und/oder Scheitelwerte und/oder Amplituden der Referenzspannungszeiger verwendet werden.

Es kann weiterhin vorgesehen sein, dass

- jeder Größenvergleich derart erfolgt, dass

    • Toleranzwerte RAB > 0, RBC > 0, RCA > 0 als das jeweilige Maß bestimmt werden;
    • geprüft wird, ob

$$\left| R_{ae} - R_{be} \right| \le R_{AB} \text{ und } \left| R_{be} - R_{ce} \right| \le R_{BC} \text{ und } \left| R_{ce} - R_{ae} \right| \le R_{CA}$$

    gilt;

- Rae der Betrag oder der Effektivwert des jeweiligen Referenzpannungszeigers der ersten Phase ist;
- Rbe der Betrag oder der Effektivwert des jeweiligen Referenzspannungszeigers der zweiten Phase ist;
- Rce der Betrag oder der Effektivwert des jeweiligen Referenzspannungszeigers der dritten Phase ist.

Jeder dieser Toleranzwerte RAB, RBC, RCA kann nach Bedarf auf beliebige Art und Weise bestimmt werden und beispielsweise auf einen Wert gesetzt werden, der 0,1% oder 0,2% oder 0,5% oder 1% oder 2% oder 3% oder 4% oder 5% oder 7% oder 10% oder 15% oder 20% oder 25% oder 30% oder 40% oder 50% des Nennwertes der jeweiligen Referenzspannung Rae, Rbe, Rce entspricht. Jeder dieser Toleranzwerte und wenigstens einer der anderen Toleranzwerte können gleich oder ungleich sein.

Es kann weiterhin vorgesehen sein, dass

- zwischen dem Ermitteln der ersten Referenzpannungszeiger und dem Ermitteln der ersten Belagspannungszeiger

    • die Phasenwinkel der ersten Referenzspannungszeiger untereinander verglichen werden,
    • das Ermitteln der ersten Belagspannungszeiger erfolgt, falls diese Winkelvergleiche ergeben, dass diese Phasenwinkel nicht mehr als ein vorbestimmtes Maß voneinander abweichen;

- zwischen dem Ermitteln der zweiten Referenzspannungszeiger und dem Ermitteln der zweiten Belagspannungszeiger

    • die Phasenwinkel der zweiten Referenzspannungszeiger untereinander verglichen werden,
    • das Ermitteln der zweiten Belagspannungszeiger erfolgt, falls diese Winkelvergleiche ergeben, dass diese Phasenwinkel nicht mehr als ein vorbestimmtes Maß voneinander abweichen.

Dieses Vergleichen der Größen der Phasenwinkel der Referenzspannungszeiger ermöglicht, dass ein Zeitpunkt bestimmt wird, zu dem die eigentliche Überwachung, nämlich der Vergleich der Verlustfaktoränderungen der Kondensatordurchführungen und das Erzeugen des Überwachungssignals, besonders vorteilhaft oder günstig ist, da sie dann nicht durch über das vorbestimmte Maß hinaus voneinander abweichende Phasenlagen erschwert, behindert oder gar unmöglich gemacht wird. Damit wird erreicht, dass unabhängig von Schwankungen der Phasenlage der Spannungen des Wechselstromnetzes sowie von Messtoleranzen beim Erfassen der Belagspannungen eine bessere Aussage über den Zustand der Kondensatordurchführungen getroffen werden kann.

Es kann weiterhin vorgesehen sein, dass

- jeder Winkelvergleich derart erfolgt, dass

    • Toleranzwerte PAB > 0, PBC > 0, PCA > 0 als das jeweilige Maß bestimmt werden;
    • geprüft wird, ob

$$\left| \varphi_a - \varphi_b \right| \le P_{AB} \text{ und } \left| \varphi_b - \varphi_c \right| \le P_{BC} \text{ und } \left| \varphi_c - \varphi_a \right| \le P_{CA}$$

    gilt;

- φa der Phasenwinkel des jeweiligen Referenzspannungszeigers der ersten Phase ist;
- φb der Phasenwinkel des jeweiligen Referenzspannungszeigers der zweiten Phase ist;
- φc der Phasenwinkel des jeweiligen Referenzspannungszeigers der dritten Phase ist. Jeder dieser Toleranzwerte PAB, PBC, PCA kann nach Bedarf auf beliebige Art und Weise bestimmt werden und beispielsweise auf einen Wert gesetzt werden, der 0,1% oder 0,2% oder 0,5% oder 1% oder 2% oder 3% oder 4% oder 5% oder 7% oder 10% oder 15% oder 20% des Normwertes des jeweiligen Phasenversatzes entspricht. Jeder dieser Toleranzwerte und wenigstens einer der anderen Toleranzwerte können gleich oder ungleich sein.

Es kann weiterhin vorgesehen sein, dass jeder Belagspannungszeiger dadurch ermittelt wird, dass die jeweilige Belagspannung wenigstens zweimal erfasst wird und diese erfassten Belagspannungen gemittelt und/oder gefiltert werden.

Es kann weiterhin vorgesehen sein, dass zum Mitteln ein gleitender Mittelwert gebildet wird; und/oder zum Mitteln ein gewichteter Mittelwert gebildet wird, wobei insbesondere für jeden Messwert ein Gewichtungsfaktor bestimmt wird, der vom Alter dieses Messwerts antiton abhängt.

Die Erfindung schlägt gemäß einem zweiten Aspekt eine Vorrichtung zum Überwachen von Kondensatordurchführungen für ein Wechselstromnetz gemäß Anspruch 17 vor. Es kann weiterhin vorgesehen sein, jeder dieser Spannungswandler als kapazitiver Spannungswandler oder induktiver Spannungswandler oder resistiver Spannungswandler ausgebildet ist.

Es kann weiterhin vorgesehen sein, dass die Messeinrichtung wenigstens einen Messkondensator oder Messshunt umfasst.

Die Ausführungen und Erläuterungen zu einem der Aspekte der Erfindung, insbesondere zu einzelnen Merkmalen dieses Aspektes, gelten entsprechend auch analog für die anderen Aspekte der Erfindung.

Im Folgenden werden Ausführungsformen der Erfindung beispielhaft anhand der beigefügten Zeichnungen näher erläutert. Die daraus hervorgehenden einzelnen Merkmale sind jedoch nicht auf die einzelnen Ausführungsformen beschränkt, sondern können mit weiter oben beschriebenen einzelnen Merkmalen und/oder mit einzelnen Merkmalen anderer Ausführungsformen verbunden und/oder kombiniert werden. Die Einzelheiten in den Zeichnungen sind nur erläuternd, nicht aber beschränkend auszulegen. Die in den Ansprüchen enthaltenen Bezugszeichen sollen den Schutzbereich der Erfindung in keiner Weise beschränken, sondern verweisen lediglich auf die in den Zeichnungen gezeigten Ausführungsformen. Die Zeichnungen zeigen in

FIG. 1    eine Ausführungsform einer Vorrichtung zur Überwachung von Kondensatordurchführungen für ein dreiphasiges Wechselstromnetz;

FIG. 2    einen Teil der Vorrichtung der FIG. 1;

FIG. 3    eine Ersatzschaltung aus einem Unterspannungskondensator und einem Oberspannungskondensator;

FIG. 4    ein Ablaufdiagramm einer Ausführungsform eines Verfahrens zur Überwachung von Kondensatordurchführungen für ein dreiphasiges Wechselstromnetz;

FIG. 5    Eine weitere Ausführungsform einer Vorrichtung zur Überwachung von Kondensatordurchführungen für ein dreiphasiges Wechselstromnetz;

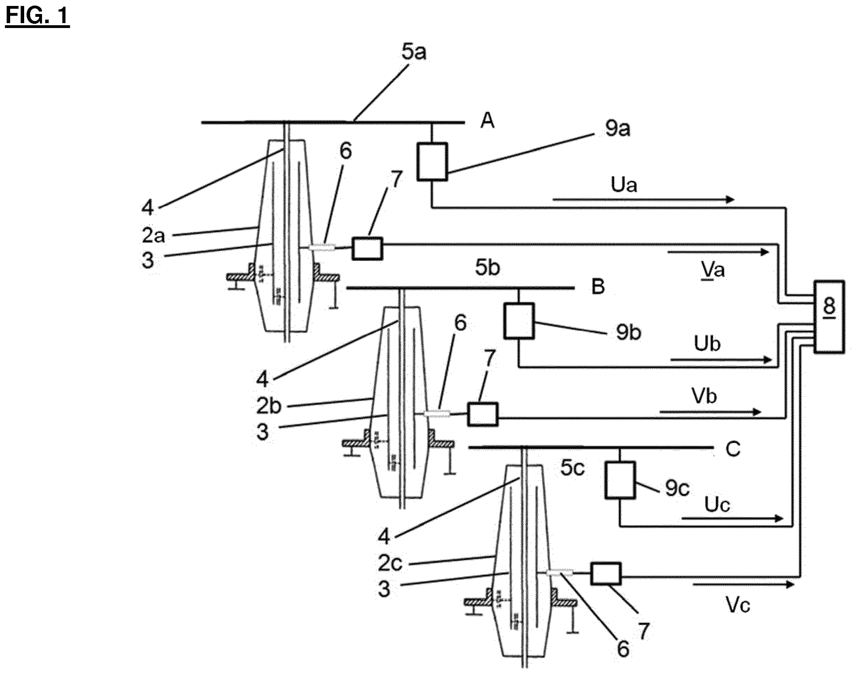

Die nachfolgend in den Ausführungen zu Fig.1 bis Fig.4 beschriebenen Ausführungen beziehen sich auf eine Ausführungsform, in der die jeweiligen Referenzspannungszeiger $\underline{R}a(tj)$, $\underline{R}b(tj)$, $\underline{R}c(tj)$ anhand der jeweiligen Netzspannungen Ua(tj), Ub(tj), Uc(tj) ermittelt werden. In den Ausführungen zu Fig.1 bis Fig. 4 werden somit die jeweiligen Netzspannungszeiger $\underline{U}a(tj)$, $\underline{U}b(tj)$, $\underline{U}c(tj)$ als Referenzspannungszeiger verwendet.

Desweiteren wird davon ausgegangen, dass aufgrund hinreichend kleiner Winkel für die nachstehenden Ausführungen zur Berechnung der Verlustfaktoränderung die Kleinwinkelnäherung angenommen werden kann.

In der FIG. 1 ist eine Ausführungsform einer Vorrichtung 1 zur Überwachung von Kondensatordurchführungen 2a, 2b, 2c für ein dreiphasiges Wechselstromnetz schematisch dargestellt. Die Kondensatordurchführungen 2a, 2b, 2c gehören bei dieser Ausführungsform zu einem hier nicht dargestellten Transformator, der hier beispielhaft ein Hochspannungstransformator ist. Derartige Kondensatordurchführungen 2a, 2b, 2c werden beispielsweise bei hohen Spannungen im Bereich von einigen wenigen kV bis zu einigen 1000 kV eingesetzt. Das Wechselstromnetz ist hier beispielhaft ein Hochspannungsnetz. Jede der drei Kondensatordurchführungen 2a, 2b, 2c ist einer der drei Phasen A,B,C des Wechselstromnetzes zugeordnet und weist einen Leiter 4, der mit der jeweiligen Netzleitung 5a, 5b, 5c des Wechselstromnetzes verbunden ist, und mehrere elektrisch leitfähige Beläge auf, die den Leiter 4 in mehreren Lagen oder Schichten umgeben und von denen lediglich der äußerste Belag 3 dargestellt ist.

**EP 3 589 964 B1**

Die Vorrichtung 1 weist eine Auswerteeinrichtung 8 sowie für jede Phase A, B, C eine Messeinrichtung 7 und einen Messadapter 6 auf, der mit dem Belag 3 der zu der jeweiligen Phase gehörenden Kondensatordurchführung 2a, 2b, 2c verbunden ist. Die Auswerteeinrichtung 8 ist mit jeder Messeinrichtung 7 verbunden, um die Belagspannungszeiger Va, Vb, Vc für die Phasen A, B, C zu ermitteln, und bildet somit eine gemeinsame Auswerteeinrichtung 8 für alle Messeinrichtungen 7.

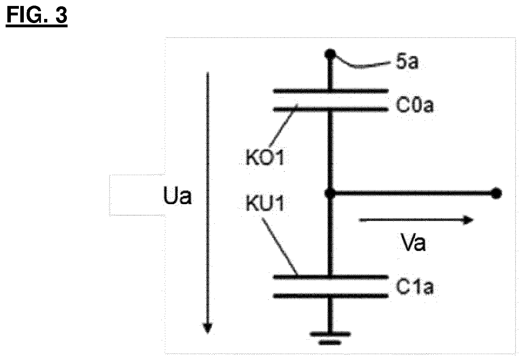

Die Belagspannungszeiger Va, Vb, Vc sind hier elektrische Spannungszeiger, die jeweils an einem weiter unten beschriebenen und in FIG. 3 gezeigten Unterspannungskondensator KU1, KU2, KU3 der jeweiligen Phase A, B, C ermittelt werden. Bei dieser Ausführungsform weist die Vorrichtung 1 zudem für jede Phase A, B, C einen Spannungswandler 9a, 9b, 9c auf, der mit der jeweiligen Netzleitung 5a, 5b, 5c verbunden ist, um eine zweite elektrische Messgröße für die jeweilige Phase A, B, C zu erfassen. Diese zweiten Messgrößen sind hier elektrische Spannungszeiger, die jeweils zwischen der jeweiligen Netzleitung 5a, 5b, 5c und Massepotenzial 13 ermittelt werden und hier auch als Netzspannungszeiger Ua, Ub, Uc bezeichnet werden. Die Auswerteeinrichtung 8 ist mit jedem Spannungswandler 9a, 9b, 9c verbunden, um die Netzspannungszeiger Ua, Ub, Uc zu ermitteln, und bildet somit eine gemeinsame Auswerteeinrichtung 8 für alle Spannungswandler 9a, 9b, 9c.

Durch die Vorrichtung 1 wird die Möglichkeit geschaffen, dass die Auswerteeinrichtung 8 bei der Überwachung der Kondensatordurchführungen 2a, 2b, 2c Asymmetrien und/oder Schwankungen der Netzspannungszeiger Ua, Ub, Uc auf den Netzleitungen 5a, 5b, 5c berücksichtigt.

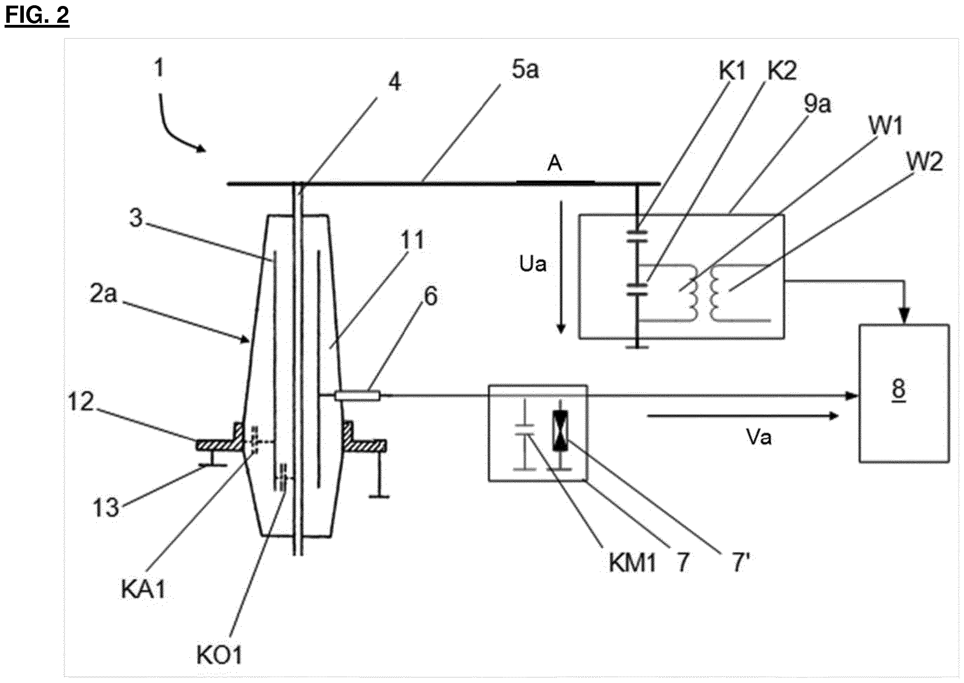

In der FIG. 2 ist ein erster Teil der Vorrichtung 1 detaillierter dargestellt, der einer ersten Phase A zugeordnet ist. Diesem ersten Teil entsprechen ein einer zweiten Phase B zugeordneter zweiter und ein einer dritten Phase C zugeordneter dritter Teil der Vorrichtung 1 analog, sodass die Ausführungen und Erläuterungen zu dem ersten Teil entsprechend auch analog für diese beiden anderen Teile gelten.

Die der ersten Phase A zugeordnete erste Kondensatordurchführung 2a weist einen Isolationskörper 11 auf, durch dessen Inneres der Leiter 4 geführt ist. Dieser kontaktiert an seinem oberen Ende die seiner Kondensatordurchführung 2a zugeordnete Netzleitung 5a und an seinem unteren Ende eine hier nicht dargestellte Wicklung des Hochspannungstransformators. Im Isolierkörper 11 sind die elektrisch leitfähigen Beläge eingebettet, die hier nur durch den äußersten Belag 3 angedeutet sind und elektrisch gesehen eine Reihenschaltung von Kondensatoren bilden. Diese Reihenschaltung weist die Kondensatoren, die jeweils von zwei benachbarten Belägen gebildet werden, sowie einen Kondensator auf, der von dem hier nicht gezeigten innersten Belag und dem Leiter 4 gebildet wird. Diese Reihenschaltung von Kondensatoren zwischen dem äußersten Belag 3 und dem Leiter 4 bildet als Ersatzschaltung für jede Kondensatordurchführung 2a, 2b, 2c einen entsprechenden Oberspannungskondensator KO1, KO2, KO3.

An der Kondensatordurchführung 2a ist ein elektrisch leitfähiger Flansch 12 angeordnet, der am Erdpotenzial oder Massepotenzial 13 anliegt. Dieser Flansch 12 dient der Befestigung und/oder Sicherung der Kondensatordurchführung 2a. Der äußerste Belag 3 bildet mit dem Flansch 12 und Massepotenzial 13 als Ersatzschaltung für jede Kondensatordurchführung 2a, 2b, 2c einen entsprechenden Außenkondensator KA1, KA2, KA3.

Der Messadapter 6 dringt durch den Isolationskörper 11 und stellt eine elektrisch leitende Verbindung zum äußersten Belag 3 her. Bei dieser Ausführungsform weist jede Messeinrichtung 7 einen Messkondensator KM1, KM2, KM3 auf, der auf Massepotenzial 13 geschaltet ist. Sie kann bei Bedarf zusätzlich eine nicht dargestellte Funkenstrecke, die parallel zu dem jeweiligen Messkondensator KM1, KM2, KM3 geschaltet ist, und/oder einen Überspannungsschutz 7' aufweisen, der parallel zu dem jeweiligen Messkondensator KM1, KM2, KM3 geschaltet ist.

Die Auswerteeinrichtung 8 ist über den Spannungswandler 9a mit der Netzleitung 5a elektrisch leitend verbunden. Bei dieser Ausführungsform ist der Spannungswandler 9a als kapazitiver Spannungswandler ausgebildet und weist einen kapazitiven Spannungsteiler, der zwei in Reihe geschaltete Kondensatoren K1, K2 aufweist, und zwei Spulen oder Wicklungen W1, W2 auf, die als Transformator zur induktiven galvanischen Trennung geschaltet sind.

In der FIG. 3 ist für die erste Phase A eine Ersatzschaltung aus dem jeweiligen Unterspannungskondensator KU1 und dem jeweiligen Oberspannungskondensator KO1 schematisch dargestellt. Eine Parallelschaltung, die den jeweiligen Messkondensator KM1 und den Außenkondensator KA1 aufweist, bildet den Unterspannungskondensator KU1 mit der Unterkapazität C1. Diese Unterkapazität C1a kann daher mit der bekannten Formel für die Reihenschaltung von Kondensatoren leicht aus der Kapazität CM1 des Messkondensators KM1 und der Kapazität CA1 des Außenkondensators KA1 berechnet werden. Bei Bedarf kann die Parallelschaltung anstelle des Messkondensators KM1 die gesamte jeweilige Messeinrichtung 7 und/oder zusätzlich die Auswerteeinrichtung 8 aufweisen, sodass dann die Unterkapazität C1a aus der Impedanz der Messeinrichtung 7, die von der Kapazität CM1 abhängt, der Kapazität CA1 und der Impedanz der Auswerteeinrichtung 8 berechnet werden muss.

Die Belagspannung V1a liegt am Unterspannungskondensator KU1 an und wird an der Verbindungsleitung oder der Verbindungsstelle zwischen dem Unterspannungskondensator KU1 und dem Oberspannungskondensator KO1 abgegriffen und auf Massepotenzial 13 bezogen. Die Netzspannung Ua fällt über der Reihenschaltung aus dem Oberspannungskondensator KO1 und dem Unterspannungskondensator KU1 ab.

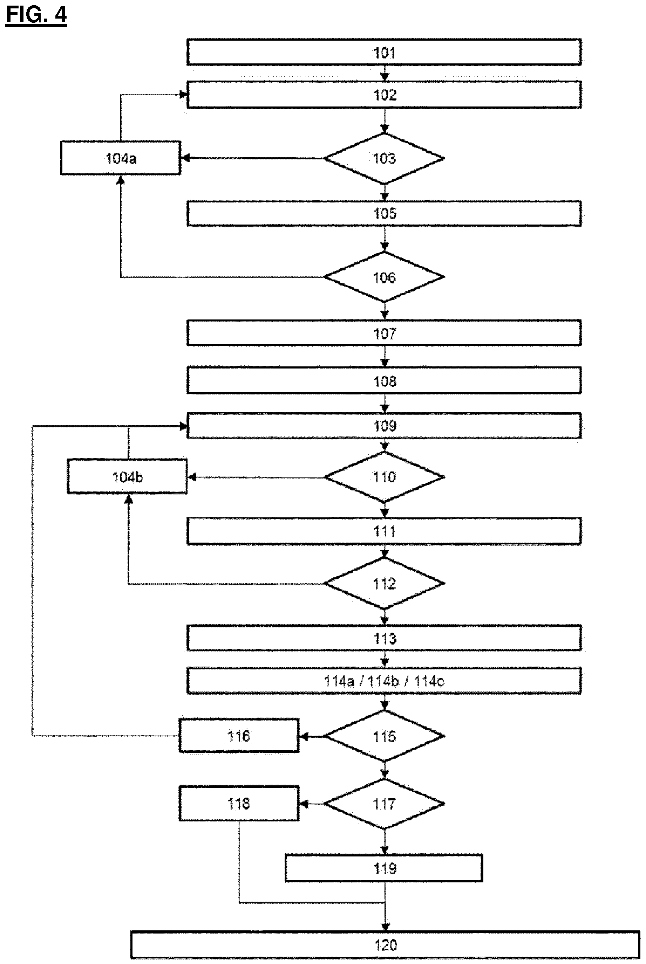

In FIG. 4 ist ein Ablaufdiagramm einer Ausführungsform eines Verfahrens zur Überwachung von Kondensatordurchführungen 2a, 2b, 2c für ein dreiphasiges Wechselstromnetz schematisch dargestellt. Dieses Verfahren kann beispielsweise durch die und/oder mithilfe der Vorrichtung 1 der FIG. 1 ausgeführt werden.

Bei dieser Ausführungsform weist das Verfahren die folgenden Schritte auf, die unter Bezugnahme auf die Vorrichtung 1 und FIG. 1-3 erläutert werden Schritt 101: Start des Verfahrens.

Schritt 102: Erfassen von ersten Netzspannungen Ua(t1), Ub(t1), Uc(t1) sowie von ersten Belagspannungen Va(t1), Vb(t1), Vc(t1) für den Zeitpunkt t1 für jede der Phasen A, B, C.

Schritt 103: Ermitteln von ersten Netzspannungszeigern Ua(t1), Ub(t1), Uc(t1) anhand der erfassten Netzspannungen Ua(t1), Ub(t1), Uc(t1) und Vergleich der Netzspannungszeiger Ua(t1), Ub(t1), Uc(t1) zum Zeitpunkt t1 untereinander.

Für den Vergleich der Netzspannungszeiger Ua(t1), Ub(t1), Uc(t1) untereinander werden in dieser Ausführungsform die Effektivwerte der Netzspannungen Uae, Ube, Uce verwendet. Weiterhin können auch die Beträge und/oder Scheitelwerte und/oder Amplituden der Netzspannungszeiger zum Vergleich herangezogen werden.

Weiterhin ist vorgesehen, dass Toleranzwerte RAB > 0, RBC > 0, RCA > 0 für den Vergleich bestimmt werden und der Vergleich derart erfolgt, dass geprüft wird, ob |Uae - Ube| ≤ RAB und |Ube - Uce| ≤ RBC und |Uce - Uae| ≤ RCA gilt.

Falls ja, dann bedeutet dies, dass der Vergleich der Netzspannungszeiger LJa(t1), Ub(t1), Uc(t1) untereinander ergibt, dass die Netzspannungszeiger nicht mehr als ein vorbestimmtes Maß RAB, RBC, RCA voneinander abweichen. In diesem Fall wird der Schritt 105 ausgeführt.

Falls nein, dann bedeutet dies, dass der Vergleich der ersten Netzspannungszeiger Ua(t1), Ub(t1), Uc(t1) untereinander ergibt, dass die ersten Netzspannungszeiger mehr als ein vorbestimmtes Maß RAB, RBC, RCA voneinander abweichen. In diesem Fall wird der Schritt 104 ausgeführt.

Schritt 104: Ein Warnsignal wird erzeugt, das einen Kurzschluss im Stromnetz und/oder eine zu starke oder übermäßige Asymmetrie der Netzspannungen Ua, Ub, Uc anzeigt. Anschließend erfolgt Sprung zu Schritt 102.

Schritt 105: Ermitteln der Phasenwinkel φa, φb, φc der ersten Netzspannungszeiger Ua(t1), Ub(t1), Uc(t1) zum Zeitpunkt t1 wobei gilt, dass cpa der Phasenwinkel des Netzspannungszeigers Ua(t1), φb der Phasenwinkel des Netzspannungszeigers Ub(t1) und cpc der Phasenwinkel des Netzspannungszeigers Uc(t1) ist.

Schritt 106: Vergleich der Phasenwinkel φa, φb, φc der ersten Netzspannungszeiger Ua(t1), Ub(t1), Uc(t1) untereinander. Für den Vergleich der Phasenwinkel der ersten Netzspannungszeiger untereinander ist vorgesehen, dass Toleranzwerte PAB > 0, PBC > 0, PCA > 0 als das Maß für den Winkelvergleich bestimmt werden. Der Größenvergleich erfolgt dann derart, dass geprüft wird, ob |φa - φb| ≤ PAB und |φb - φc| ≤ PBC und |φc - φa| ≤ PCA gilt.

Falls ja, dann bedeutet dies, dass der Phasenwinkelvergleich ergibt, dass die Phasenwinkel der ersten Netzspannungszeiger φa, φb, φc nicht mehr als ein vorbestimmtes Maß PAB, PBC, PCA voneinander abweichen. In diesem Fall wird der Schritt 107 ausgeführt.

Falls nein, dann bedeutet dies, dass der Phasenwinkelvergleich ergibt, dass die Phasenwinkel der ersten Netzspannungen φa, φb, φc mehr als ein vorbestimmtes Maß PAB, PBC, PCA voneinander abweichen. In diesem Fall erfolgt der Sprung zu Schritt 104a.

Schritt 107: Ermitteln von ersten Belagspannungszeigern Va(t1), Vb(t1), Vc(t1) für den Zeitpunkt t1 anhand der in Schritt 102 gemessenen Belagspannungen Va(t1) Vb(t1), Vc(t1), die zwischen dem jeweiligen Belag 3 und Massepotential 13 zum Zeitpunkt t1 anliegt.

Schritt 108: Ermitteln und Archivieren des Phasenversatzes θab, θbc, θac zwischen den Belagspannungszeigern Va(t1), Vb(t1), Vc(t1) zum vorbestimmten Zeitpunkt t1 gemäß folgender Formeln

$$\theta_{ab}(t_j) = \left( \arccos \frac{\underline{V}_a(t_j) \cdot \underline{V}_b(t_j)}{\left|\underline{V}_a(t_j)\right| \cdot \left|\underline{V}_b(t_j)\right|} - \arccos \frac{\underline{U}_a(t_j) \cdot \underline{U}_b(t_j)}{\left|\underline{U}_a(t_j)\right| \cdot \left|\underline{U}_b(t_j)\right|} \right), \quad j = 1$$

$$\theta_{bc}(t_j) = \left( \arccos \frac{\underline{V}_b(t_j) \cdot \underline{V}_c(t_j)}{\left|\underline{V}_b(t_j)\right| \cdot \left|\underline{V}_c(t_j)\right|} - \arccos \frac{\underline{U}_b(t_j) \cdot \underline{U}_c(t_j)}{\left|\underline{U}_b(t_j)\right| \cdot \left|\underline{U}_c(t_j)\right|} \right), \quad j = 1$$

$$\theta_{ca}(t_j) = \left( \arccos \frac{\underline{V}_c(t_j) \cdot \underline{V}_a(t_j)}{\left|\underline{V}_c(t_j)\right| \cdot \left|\underline{V}_a(t_j)\right|} - \arccos \frac{\underline{U}_c(t_j) \cdot \underline{U}_a(t_j)}{\left|\underline{U}_c(t_j)\right| \cdot \left|\underline{U}_a(t_j)\right|} \right), \quad j = 1$$

wobei

- $\underline{U}a(tj)$, $\underline{U}b(tj)$, $\underline{U}c(tj)$ die ersten Netzspannungszeiger der ersten, zweiten und dritten Phase zum Zeitpunkt j sind;
- $\underline{V}a(tj)$, $\underline{V}b(tj)$, $\underline{V}c(tj)$ die ersten Belagspannungszeiger der ersten, zweiten und dritten Phase zum Zeitpunkt j sind.

Schritt 109: Erfassen von zweiten Netzspannungen Ua(t2), Ub(t2), Uc(t2) sowie von zweiten Belagspannungen Va(t2), Vb(t2), Vc(t2) und Ermitteln von zweiten Netzspannungszeigern $\underline{U}a(t2)$, $\underline{U}b(t2)$, $\underline{U}c(t2)$ für einen Zeitpunkt t2, der nach dem Zeitpunkt t1 liegt, anhand der zum Zeitpunkt t2 erfassten Netzspannungen Ua(t2), Ub(t2), Uc(t2) für jede der Phasen A, B, C.

Schritt 110: Vergleich der Netzspannungszeiger $\underline{U}a(t2)$, $\underline{U}b(t2)$ $\underline{U}c(t2)$ zum Zeitpunkt t2 untereinander.

Der Vergleich der Netzspannungszeiger zum Zeitpunkt t2 erfolgt analog zum Vergleich der ersten Netzspannungszeiger zum Zeitpunkt t1 aus Schritt 103. Falls die Netzspannungszeiger $\underline{U}a(t2)$, $\underline{U}b(t2)$, $\underline{U}c(t2)$ mehr als ein vorbestimmtes Maß RAB, RBC, RCA voneinander abweichen wird Schritt 104 ausgeführt, ansonsten wird mit Schritt 111 fortgefahren.

Schritt 111: Ermitteln der Phasenwinkel φa, φb, φc der zweiten Netzspannungszeiger $\underline{U}a(t2)$, $\underline{U}b(t2)$, $\underline{U}c(t2)$ zum Zeitpunkt t2 wobei gilt, dass cpa der Phasenwinkel des Netzspannungszeigers $\underline{U}a(t2)$, cpb der Phasenwinkel des Netzspannungszeigers $\underline{U}b(t2)$ und cpc der Phasenwinkel des Netzspannungszeigers $\underline{U}c(t2)$ ist.

Schritt 112: Vergleich der Phasenwinkel φa(t2), φb(t2), φc(t2) der zweiten Netzspannungszeiger $\underline{U}a(t2)$, $\underline{U}b(t2)$, $\underline{U}c(t2)$ zum Zeitpunkt t2 analog zu Schritt 106.

Falls die Phasenwinkel der zweiten Netzspannungszeiger mehr als ein vorbestimmtes Maß PAB, PBC, PCA voneinander abweichen wird Schritt 104b ausgeführt, ansonsten wird mit Schritt 113 fortgefahren.

Schritt 104b: Ein Warnsignal wird erzeugt, das einen Kurzschluss im Stromnetz und/oder eine zu starke oder übermäßige Asymmetrie der Netzspannungen Ua, Ub, Uc anzeigt. Anschließend erfolgt nach Bedarf der Sprung zu Schritt 109.

Schritt 113: Es werden zweite Belagspannungszeiger Va(t2), Vb(t2), Vc(t2) für den Zeitpunkt t2 anhand einer gemessenen Belagspannung, die zwischen dem jeweiligen Belag 3 und Massepotential 13 zum Zeitpunkt t2 anliegt ermittelt. Weiterhin wird für den Zeitpunkt t2 der jeweilige Phasenversatz θab (t2), θbc (t2), θac(t2) zwischen den benachbarten

Konsensatordurchführungen aus den Belagspannungszeigern Va(t2), Vb(t2), Vc(t2) gemäß folgender Formeln ermittelt und archiviert.

$$\theta_{ab}(t_j) = \left( \arccos \frac{\underline{V}_a(t_j) \cdot \underline{V}_b(t_j)}{\left|\underline{V}_a(t_j)\right| \cdot \left|\underline{V}_b(t_j)\right|} - \arccos \frac{\underline{U}_a(t_j) \cdot \underline{U}_b(t_j)}{\left|\underline{U}_a(t_j)\right| \cdot \left|\underline{U}_b(t_j)\right|} \right), j = 2$$

$$\theta_{bc}(t_j) = \left( \arccos \frac{\underline{V}_b(t_j) \cdot \underline{V}_c(t_j)}{\left|\underline{V}_b(t_j)\right| \cdot \left|\underline{V}_c(t_j)\right|} - \arccos \frac{\underline{U}_b(t_j) \cdot \underline{U}_c(t_j)}{\left|\underline{U}_b(t_j)\right| \cdot \left|\underline{U}_c(t_j)\right|} \right), j = 2$$

$$\theta_{ca}(t_j) = \left( \arccos \frac{\underline{V}_c(t_j) \cdot \underline{V}_a(t_j)}{\left|\underline{V}_c(t_j)\right| \cdot \left|\underline{V}_a(t_j)\right|} - \arccos \frac{\underline{U}_c(t_j) \cdot \underline{U}_a(t_j)}{\left|\underline{U}_c(t_j)\right| \cdot \left|\underline{U}_a(t_j)\right|} \right), j = 2$$

Etwaige Messwerte aus möglichen vorherigen Verfahrensdurchläufen, die zwischen einem Zeitpunkt t1 und einem Zeitpunkt t2 aufgenommen wurden, werden in dieser Ausführungsform nicht berücksichtigt.

Schritt 114a: In dieser Ausführungsform werden für jede Kondensatordurchführung 2a, 2b, 2c eine Verlustfaktoränderung ΔDa, ΔDb, ΔDc in Abhängigkeit vom zuvor zu verschiedenen Zeitpunkten ermittelten Phasenversatz θab(tj), θbc (tj), θac(tj) zwischen den benachbarten Kondensatordurchführungen gemäß folgender Formel berechnet.

$$\Delta D_a(t_2) = \theta_{ab}(t_2) - \theta_{ab}(t_1)$$

$$\Delta D_b(t_2) = \theta_{bc}(t_2) - \theta_{bc}(t_1)$$

$$\Delta D_c(t_2) = \theta_{ca}(t_2) - \theta_{ca}(t_1)$$

ΔDa (t2) beschreibt somit die Verlustfaktoränderung der Kondensatordurchführung 2a zum Zeitpunkt t2 im Vergleich zum Zeitpunkt t1. ΔDb (t2) beschreibt die Verlustfaktoränderung der Kondensatordurchführung 2b zum Zeitpunkt t2 im Vergleich zum Zeitpunkt t1. ΔDc (t2) beschreibt die Verlustfaktoränderung der Kondensatordurchführung 2c zum Zeitpunkt t2 im Vergleich zum Zeitpunkt t1.

Gemäß dieser Ausführungsform erfolgt die Ermittlung der Verlustfaktoränderung der Kondensatordurchführungen 2a, 2b, 2c auch für spätere Zeitpunkte t3, t4,...tn, die nach dem Zeitpunkt t2 liegen, unter Bezugnahme auf den ersten Zeitpunkt t1.

Schritt 115: Für jede Kondensatordurchführung werden die in Schritt 114a identifizierten Verlustfaktoränderungen der Kondensatordurchfürungen 2a, 2b, 2c verglichen. In dieser Ausführungsform ist vorgesehen, dass Toleranzwerte DA > 0, DB > 0, DC > 0 für die Verlustfaktoränderung der jeweiligen Kondensatordurchführungen bestimmt werden und der Vergleich derart erfolgt, dass geprüft wird ob,

$$\left|\Delta D_a(t_2)\right| \le D_A \ \text{und} \ \left|\Delta D_b(t_2)\right| \le D_B \ \text{und} \ \left|\Delta D_c(t_2)\right| \le D_C$$

gilt. Ist dies der Fall wird Schritt 116 ausgeführt. Falls dies nicht der Fall ist, wird Schritt 117 ausgeführt.

Schritt 116: Ein Überwachungssignal wird erzeugt, das anzeigt, dass die Kondensatordurchführungen 2a, 2b, 2c in ordnungsgemäßem Zustand sind. Anschließend erfolgt der Sprung zu Schritt 109.

Schritt 117: Der Verlustfaktorvergleich erfolgt außerdem derart, dass geprüft wird, ob in einem ersten Fall gilt

$$\left|\Delta D_a(t_2)\right| > D_A \ \text{und} \ \left|\Delta D_b(t_2)\right| > D_B \ \text{und} \ \left|\Delta D_c(t_2)\right| \le D_C$$

oder in einem zweiten Fall gilt

$$\left|\Delta D_a(t_2)\right| \le D_A \ \text{und} \ \left|\Delta D_b(t_2)\right| > D_B \ \text{und} \ \left|\Delta D_c(t_2)\right| > D_C$$

oder in einem dritten Fall gilt

$$\left|\Delta D_a(t_2)\right| > D_A \ \text{und} \ \left|\Delta D_b(t_2)\right| \le D_B \ \text{und} \ \left|\Delta D_c(t_2)\right| > D_C$$

Tritt einer der drei oben genannten Fälle ein, erfolgt ein Sprung zu Schritt 118. Falls dies nicht der Fall ist, wird Schritt 119 ausgeführt.

Schritt 118: Abhängig von dem Verlustvergleich aus Schritt 117 wird ein Überwachungssignal erzeugt.

Ist in Schritt 117 der erste Fall eingetreten, zeigt das Überwachungssignal an, dass entweder die zweite Kondensatordurchführung 2b nicht in ordnungsgemäßem Zustand ist oder die beiden anderen Kondensatordurchführungen 2a, 2c nicht in ordnungsgemäßem Zustand sind und einen gleichartigen Fehler haben.

Ist in Schritt 117 der zweite Fall eingetreten, zeigt das Überwachungssignal an, dass entweder die dritte Kondensatordurchführung 2c nicht in ordnungsgemäßem Zustand ist oder die beiden anderen Kondensatordurchführungen 2b, 2a nicht in ordnungsgemäßem Zustand sind und einen gleichartigen Fehler haben.

Ist in Schritt 117 der dritte Fall eingetreten, zeigt das Überwachungssignal an, dass entweder die erste Kondensatordurchführung 2a nicht in ordnungsgemäßem Zustand ist oder die beiden anderen Kondensatordurchführungen 2c, 2b nicht in ordnungsgemäßem Zustand sind und einen gleichartigen Fehler haben.

Schritt 119: Tritt keiner der drei oben erwähnten Fälle ein wird ein Überwachungssignal erzeugt, das anzeigt, dass entweder alle drei Kondensatordurchführungen 2a, 2b, 2c nicht in ordnungsgemäßem Zustand sind oder zwei Kondensatordurchführungen nicht in ordnungsgemäßem Zustand sind und keinen gleichartigen Fehler haben. Anschließend wird das Verfahren beendet (Schritt 120) oder es erfolgt nach Bedarf ein Sprung zu Schritt 109.

Nachstehend werden alternative Ausführungsformen 114b, 114c des Schrittes 114a näher erläutert.

Im Gegensatz zum Vorgehen in Schritt 114a kann in einem Schritt 114b die Ermittlung der Verlustfaktoränderung der jeweiligen Kondensatordurchführung für Messwerte zu einem Zeitpunkt t3, t4,... tn die nach dem Zeitpunkt t2 liegen auch unter Bezugnahme auf den vorhergehenden Messwert erfolgen. Dies ist exemplarisch für einen Zeitpunkt t3, der nach dem Zeitpunkt t2 liegt durch nachstehende Formeln abgebildet:

$$\Delta D_a(t_3) = \theta_{ab}(t_3) - \theta_{ab}(t_2)$$

$$\Delta D_b(t_3) = \theta_{bc}(t_3) - \theta_{bc}(t_2)$$

$$\Delta D_a(t_3) = \theta_{ca}(t_3) - \theta_{ca}(t_2)$$

In einer weiteren alternativen Ausführungsform können in einem Schritt 114c auch eine Vielzahl von Messwerten, die zwischen einem ersten Zeitpunkt t1 und einem späteren Zeitpunkt tn liegen zur Ermittlung der Verlustfaktoränderung der jeweiligen Kondensatordurchführung herangezogen werden. Vorteilhaft können die einzelnen Messwerte t1,..., tn auch mit einem Gewichtungsfaktor versehen werden. Diese Ausführungsform des Schrittes 114c ist beispielhaft anhand nachstehender Formeln abgebildet.

Für die Ermittlung der Verlustfaktoränderung einer ersten Kondensatordurchführung 2a gilt somit:

$$\Delta D_a(t_n) = \sum_{i=2}^{n} \left\{ g_{ai}[\theta_{ab}(t_i) - \theta_{ab}(t_{i-1})] \right\}$$

mit

$$\sum_{i=2}^{n} g_{ai} = 1$$

Für die Ermittlung der Verlustfaktoränderung einer zweiten Kondensatordurchführung 2b gilt:

$$\Delta D_b(t_n) = \sum_{i=2}^{n} \left\{ g_{bi}[\theta_{bc}(t_i) - \theta_{bc}(t_{i-1})] \right\}$$

mit

$$\sum_{i=2}^{n} g_{bi} = 1$$

Für die Ermittlung der Verlustfaktoränderung einer dritten Kondensatordurchführung 2c gilt:

$$\Delta D_c(t_n) = \sum_{i=2}^{n} \left\{ g_{ci}[\theta_{ca}(t_i) - \theta_{ca}(t_{i-1})] \right\}$$

mit

$$\sum_{i=2}^{n} g_{ci} = 1$$

Wobei

- n > 2 die Anzahl der Zeitpunkte ist;
- gai, gbi, gci i-te Gewichtungsfaktoren für die erste, zweite und dritte Kondensatordurchführung sind.

Die Gewichtungsfaktoren können dabei antiton vom Alter der jeweiligen Kondensatordurchführung oder dem Einbauort oder statistischen oder probabilistischen Methoden oder weiteren Erfahrungswerten abhängen.

Die Schritte 102, 109 können beispielsweise durch die Spannungswandler 9a, 9b, 9c, die Messadapter 6, die Messeinrichtungen 7 und die Auswerteeinrichtung 8 ausgeführt werden, die somit Mittel bilden, die derart ausgebildet sind, dass sie die Netzspannungen sowie Belagspannungen verschiedener Zeitpunkte $Ua(tj)$, $Ub(tj)$, $Uc(tj)$, $Va(tj)$, $Vb(tj)$, $Vc(tj)$ erfassen.

Die Schritte 103, 105, 106, 110, 111, 112 können beispielsweise durch die Spannungswandler 9a, 9b, 9c und die Auswerteeinrichtung 8 ausgeführt werden, die somit Mittel bilden, die derart ausgebildet sind, dass sie die Netzspannungszeiger verschiedener Zeitpunkte ermitteln und untereinander vergleichen.

Die Schritte 104a, 104b, 116, 118, 119 können beispielweise durch die Auswerteeinrichtung 8 ausgeführt werden, das somit Mittel bildet, die derart ausgebildet sind, dass sie ein Überwachungssignal erzeugen, das von den Ergebnissen des Vergleichs der Netzspannungen, Phasenlagen sowie Verlustfaktoränderungen abhängt.

Die Schritte 107, 108, 113, 114a, 114b, 114c können beispielsweise durch die Auswerteeinrichtung 8 und den Messadapter 6 und die Messeinrichtung 7 ausgeführt werden, die somit Mittel bilden, die derart ausgebildet sind, dass sie die Belagsspannungszeiger zu unterschiedlichen Zeitpunkten ermitteln und untereinander vergleichen können.

Schritte 115, 117 können beispielsweise durch die Auswerteeinrichtung 8 ausgeführt werden, die somit Mittel bildet, die derart ausgebildet sind, dass sie die Änderung des Verlustfaktors der jeweiligen Kondensatordurchführung untereinander vergleicht.

Vorteilhaft werden die Schritte 103/105 und/oder die Schritte 110/112 parallel zueinander ausgeführt.

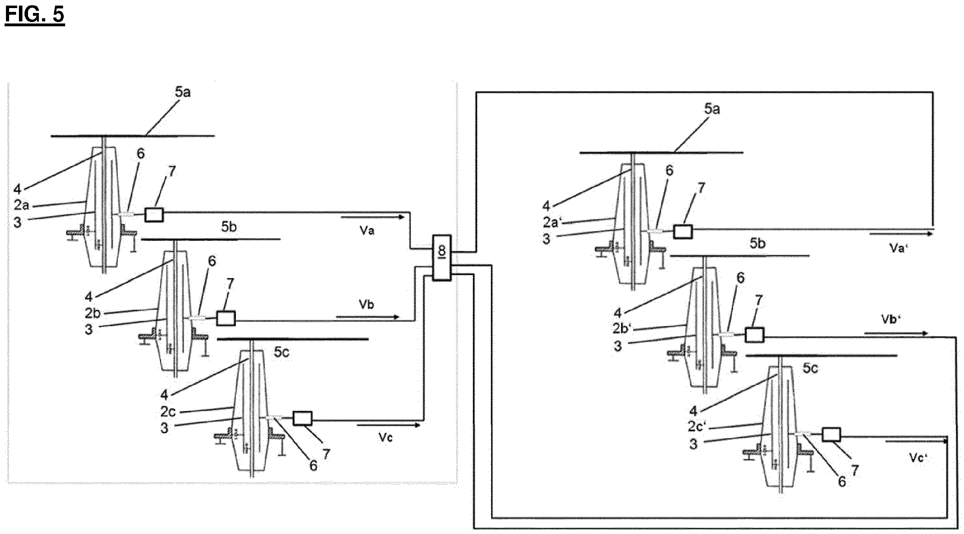

In Fig. 5 ist eine weitere Ausführungsform einer Vorrichtung zur Überwachung von Kondensatordurchführungen für ein dreiphasiges Wechselstromnetz gezeigt. Anders als in den bisherigen Ausführungen wird hier der Referenzspannungszeiger $Ra(tj)$, $Rb(tj)$, $Rc(tj)$ zum Vergleich der Verlustfaktoränderungen nicht durch einen Spannungsteiler 9a, 9b, 9c an der jeweiligen Netzleitung 5a, 5b, 5c ermittelt, sondern anhand einer Gruppe parallel geschalteter Kondensatordurchführungen 2a', 2b', 2c' an einem zweiten Hochspannungstransformator (nicht dargestellt) ermittelt. Die Parallel-Kondensatordurchführungen 2a', 2b', 2c' sind dabei an derselben Netzleitung 5a, 5b, 5c wie die Kondensatordurchführungen 2a, 2b, 2c angeschlossen.

Analog zu den Ausführungen zu FIG. 2 ist jeder Parallel-Kondensatordurchführung 2a', 2b' 2c' eine Messeinrichtung bestehend aus einem Messadapter 6, und einer Messeinrichtung 7, zugeordnet. Die Auswerteeinrichtung 8 ist über die jeweilige Messeinrichtung 7 und den jeweiligen Messadapter 6 elektrisch leitend mit den Parallel-Kondensatordurchführungen 2a', 2b', 2c' verbunden. Mittels diese Verbindung werden die Belagspannungszeiger $Va'$, $Vb'$, $Vc'$ der Parallel-Kondensatordurchführungen ermittelt.

Für den Verfahrensablauf werden in dieser alternativen Ausführungsform die Belagspannungszeiger $Va'(tj)$, $Vb'(tj)$, $Vc'(tj)$ als Referenzspannungszeiger $Ra(tj)$, $Rb(tj)$ $Rc(tj)$ genutzt.

Die Phasenwinkel $\varphi a$, $\varphi b$, $\varphi c$ werden im in Fig. 5 vorgestellten Verfahrensablauf durch die Phasenwinkel $\varphi a'$, $\varphi b'$, $\varphi c'$ der Belagspannungszeiger $Va'$, $Vb'$ $Vc'$ ersetzt.

Analog dazu werden auch die Toleranzwerte für die Phasenvergleiche PAB, PBC, PCA sowie die Toleranzwerte für die Spannungsvergleiche RAB, RBC, RCA bei Bedarf durch alternative Toleranzwerte für den Phasenvergleich PAB', PBC', PCA' der Belagspannungszeiger Va', Vb', Vc' sowie durch alternative Toleranzwerte RAB', RBC', RCA' für den Spannungsvergleich anhand der parallelen Belagspannungszeiger Va', Vb', Vc' ersetzt.

In einer weiteren Ausführungsform können als Referenzspannungen auch Konstantspannungen, für die entsprechende Konstantspannungszeiger vorbestimmt werden, genutzt werden.

Die Größe jedes Konstantspannungszeigers entspricht in diesem Fall vorzugsweise dem Nennspannungswert des Wechselstromnetzes.

Die Phasenwinkel $\varphi a$, $\varphi b$, $\varphi c$ gemäß des in den Ausführungen zu Fig. 5 beschriebenen Verfahrensablaufs werden in dieser Ausführungsform konstant auf 0°, 120°, 240° festgelegt.

**BEZUGSZEICHEN**

| | |
|---|---|
| 1 | Vorrichtung |
| 2a, 2b, 2c | Kondensatordurchführung |
| 2a', 2b', 2c' | Parallel-Kondensatordurchführung |

| | |
|---|---|
| 3 | Belag |
| 4 | Leiter |
| 5a, 5b, 5c | Netzleitung |
| 6 | Messadapter |
| 7 | Messeinrichtung |
| 7' | Überspannungsschutz |
| 8 | Auswerteeinrichtung |
| 9a, 9b, 9c | Spannungswandler |
| 11 | Isolationskörper |
| 12 | Flansch |
| 13 | Massepotential |
| K1, K2 | Kondensatoren |
| W1, W2 | Wicklungen |
| A, B, C | erste, zweite, dritte Phase |
| Ra, Rb, Rc | Referenzspannung |
| Ra(tj), Rb(tj), Rc(tj) | Referenzspannungszeiger zum Zeitpunkt tj |
| Ua, Ub, Uc | Netzspannung |
| Ua(tj), Ub(tj), Uc(tj) | Netzspannungszeiger zum Zeitpunkt tj |
| Va, Vb, Vc | Belagspannung |
| Va(tj), Vb(tj), Vc(tj) | Belagspannungszeiger zum Zeitpunkt tj |
| Va', Vb', Vc' | Belagspannung an Parallel-Kondensatordurchführungen |
| Va'(tj), Vb'(tj), Vc'(tj) | Belagspannungszeiger an Parallel-Kondensatordurchführungen |
| Uae, Ube, Uce | Effektivwerte der Netzspannung |
| KO1, KO2, KO3 | erster, zweiter, dritter Oberspannungskondensator |
| KU1, KU2, KU3 | erster, zweiter, dritter Unterspannungskondensator |
| KA1, KA2, KA3 | erster, zweiter, dritter Außenkondensator |
| KM1, KM2, KM3 | erster, zweiter, dritter Messkondensator |
| C0a, C0b, C0c | Oberkapazität von KO1, KO2, KO3 |
| C1a, C1b, C1c | Unterkapazität von KU1, KU2, KU3 |
| CA1, CA2, CA3 | Kapazität von KA1, KA2, KA3 |
| CM1, CM2, CM3 | Kapazität von KM1, KM2, KM3 |
| $\theta$ab, $\theta$bc, $\theta$ac | Phasenversatz zwischen Belagspannungszeigern Va, Vb, Vc |
| $\Delta$Da, $\Delta$Db, $\Delta$Dc | Verlustfaktoränderung der Kondensatordurchführung |
| DA, DB, DC | Toleranzwerte für Verlustfaktoränderung |
| PAB, PBC, PCA | Toleranzwerte für Phasenvergleiche |
| RAB, RBC, RCA | Toleranzwerte für Spannungsvergleiche |
| $\varphi$a, $\varphi$b, $\varphi$c | Phasenwinkel der Referenzspannungszeiger |
| gai, gbi, gci | Gewichtungsfaktoren |

**Patentansprüche**

1. Verfahren zum Überwachen von Kondensatordurchführungen (2a, 2b, 2c) für ein Wechselstromnetz, wobei

- das Wechselstromnetz eine erste, zweite und dritte Phase (A, B, C) hat und umfasst

• eine erste Netzleitung (5a), der die erste Phase (A) und eine erste Kondensatordurchführung (2a) zugeordnet sind und an der eine erste Netzspannung anliegt,
• eine zweite Netzleitung (5b), der die zweite Phase (B) und eine zweite Kondensatordurchführung (2b) zugeordnet sind und an der eine zweite Netzspannung anliegt,
• eine dritte Netzleitung (5c), der die dritte Phase (C) und eine dritte Kondensatordurchführung (2c) zugeordnet sind und an der eine dritte Netzspannung anliegt;

- jede dieser Kondensatordurchführungen (2a, 2b, 2c) umfasst

• einen Leiter (4), der mit der zugeordneten Netzleitung (5a, 5b, 5c) verbunden ist;
• einen elektrisch leitfähigen Belag (3), der diesen Leiter (4) umgibt;

- zu einem vorbestimmten ersten Zeitpunkt (t1) für jede dieser Phasen (A, B, C)

  • für eine erste Referenzspannung ein entsprechender erster Referenzspannungszeiger (Ra(t1), Rb(t1), Rc(t1)) ermittelt wird;
  • eine Belagspannung, die zwischen dem jeweiligen Belag (3) und Massepotenzial (13) anliegt, erfasst und ein entsprechender erster Belagspannungszeiger (Va(t1), Vb(t1), Vc(t1)) ermittelt wird;

- zu einem vorbestimmten zweiten Zeitpunkt (t2), der nach dem ersten Zeitpunkt (t1) liegt, für jede dieser Phasen (A, B, C)

  • für eine zweite Referenzspannung ein entsprechender zweiter Referenzspannungszeiger (Ra(t2),Rb(t2), Rc(t2)) ermittelt wird;
  • die Belagspannung erfasst und ein entsprechender zweiter Belagspannungszeiger (Va(t2), Vb(t2), Vc(t2)) ermittelt wird;

**dadurch gekennzeichnet, dass**
- für jede dieser Kondensatordurchführungen (2a, 2b, 2c)

  • eine Verlustfaktoränderung (ΔDa, ΔDb, ΔDc) in Abhängigkeit von den jeweiligen ersten und zweiten Referenzspannungszeigern und Belagspannungszeigern sowie von den ersten und zweiten Referenzspannungszeigern und Belagspannungszeigern der jeweils benachbarten Kondensatordurchführung (2b, 2c, 2a) berechnet wird

- die Verlustfaktoränderung der ersten Kondensatordurchführung (2a) gemäß folgender Formel

$$\Delta D_a(t_2) = \theta_{ab}(t_2) - \theta_{ab}(t_1)$$

mit

$$\theta_{ab}(t_j) = \left( \arccos \frac{\underline{V}_a(t_j) \cdot \underline{V}_b(t_j)}{\left|\underline{V}_a(t_j)\right| \cdot \left|\underline{V}_b(t_j)\right|} - \arccos \frac{\underline{R}_a(t_j) \cdot \underline{R}_b(t_j)}{\left|\underline{R}_a(t_j)\right| \cdot \left|\underline{R}_b(t_j)\right|} \right), j = 1, 2$$

berechnet wird; und/oder
- die Verlustfaktoränderung der zweiten Kondensatordurchführung (2b) gemäß folgender Formel

$$\Delta D_b(t_2) = \theta_{bc}(t_2) - \theta_{bc}(t_1)$$

mit

$$\theta_{bc}(t_j) = \left( \arccos \frac{\underline{V}_b(t_j) \cdot \underline{V}_c(t_j)}{\left|\underline{V}_b(t_j)\right| \cdot \left|\underline{V}_c(t_j)\right|} - \arccos \frac{\underline{R}_b(t_j) \cdot \underline{R}_c(t_j)}{\left|\underline{R}_b(t_j)\right| \cdot \left|\underline{R}_c(t_j)\right|} \right), j = 1, 2$$

berechnet wird; und/oder
- die Verlustfaktoränderung der dritten Kondensatordurchführung (2c) gemäß folgender Formel

$$\Delta D_c(t_2) = \theta_{ca}(t_2) - \theta_{ca}(t_1)$$

mit

$$\theta_{ca}(t_j) = \left( \arccos \frac{\underline{V}_c(t_j) \cdot \underline{V}_a(t_j)}{\left|\underline{V}_c(t_j)\right| \cdot \left|\underline{V}_a(t_j)\right|} - \arccos \frac{\underline{R}_c(t_j) \cdot \underline{R}_a(t_j)}{\left|\underline{R}_c(t_j)\right| \cdot \left|\underline{R}_a(t_j)\right|} \right), j = 1, 2$$

berechnet wird; wobei

- Ra(t1), Rb(t1), Rc(t1) die ersten Referenzspannungszeiger der ersten, zweiten und dritten Phase sind;
- Va(t1), Vb(t1), Vc(t1) die ersten Belagspannungszeiger der ersten, zweiten und dritten Phase sind;
- Ra(t2), Rb(t2), Rc(t2) die zweiten Referenzspannungszeiger der ersten, zweiten und dritten Phase sind;
- Va(t2), Vb(t2), Vc(t2) die zweiten Belagspannungszeiger der ersten, zweiten und dritten Phase sind.

• die Verlustfaktoränderung mit einem Toleranzwert (DA, DB, DC) verglichen wird;

- ein Überwachungssignal in Abhängigkeit von den Ergebnissen dieser Verlustfaktorvergleiche erzeugt wird.

2. Verfahren nach einem der vorigen Ansprüche, wobei

- jede Referenzspannung die jeweilige Netzspannung (Ua(t1), Ua(t2), Ub(t1,) Ub(t2), Uc(t1), Uc(t2)) ist.

3. Verfahren nach Anspruch 1, wobei

- der ersten Netzleitung (5a) eine erste Parallel-Kondensatordurchführung (2a') zugeordnet ist;
- der zweiten Netzleitung (5b) eine zweite Parallel-Kondensatordurchführung (2b') zugeordnet ist;
- der dritten Netzleitung (5c) eine dritte Parallel-Kondensatordurchführung (2c') zugeordnet ist;
- jede dieser Parallel-Kondensatordurchführungen (2a', 2b', 2c') umfasst

• einen Leiter (4), der mit der zugeordneten Netzleitung (5a, 5b, 5c) verbunden ist,
• einen elektrisch leitfähigen Belag (3), der diesen Leiter (4) umgibt;

- für jede dieser Phasen (A, B, C)

• die erste und zweite Referenzspannung eine erste und zweite Belagspannung (Va'(t1), Vb'(t1), Vc'(t1), Va'(t2), Vb'(t2), Vc'(t2)) ist, die jeweils zum ersten Zeitpunkt und zum zweiten Zeitpunkt zwischen dem Belag (3) und Massepotenzial (13) der jeweiligen Parallel-Kondensatordurchführung anliegt.

4. Verfahren nach Anspruch 1 oder einem der vorigen Ansprüche, wobei

- für jede dieser Phasen (A, B, C)

• die Referenzspannung eine Konstantspannung ist, für die ein entsprechender Konstantspannungszeiger vorbestimmt wird.

5. Verfahren nach dem vorigen Anspruch, wobei

- die Größe jedes Konstantspannungszeigers gleich einem Nennspannungswert des Wechselstromnetzes ist;
- für die erste Phase (A) der Phasenwinkel des ersten und zweiten Konstantspannungszeigers (Ra(t1), Ra(t2)) 0° beträgt;
- für die zweite Phase (B) der Phasenwinkel des ersten und zweiten Konstantspannungszeigers (Rb(t1), Rb(t2)) 120° beträgt;
- für die dritte Phase (C) der Phasenwinkel des ersten und zweiten Konstantspannungszeigers (Rc (t1), Rc(t2)) 240° beträgt.

6. Verfahren nach einem der vorigen Ansprüche, wobei

- Toleranzwerte DA > 0, DB > 0, DC > 0 für die Verlustfaktorvergleiche bestimmt werden;
- falls die Verlustfaktorvergleiche ergeben, dass

$$\left|\Delta D_a(t_2)\right| \le D_A \text{ und } \left|\Delta D_b(t_2)\right| \le D_B \text{ und } \left|\Delta D_c(t_2)\right| \le D_C$$

gilt, dann ein Überwachungssignal erzeugt wird, das anzeigt, dass die Kondensatordurchführungen (2a, 2b, 2c) in ordnungsgemäßem Zustand sind.

**7.** Verfahren nach einem der vorigen Ansprüchen, wobei

- Toleranzwerte DA > 0, DB > 0, DC > 0 für die Verlustfaktorvergleiche bestimmt werden;
- falls die Verlustfaktorvergleiche ergeben, dass

$$\left|\Delta D_a(t_2)\right| > D_A \text{ und } \left|\Delta D_b(t_2)\right| > D_B \text{ und } \left|\Delta D_c(t_2)\right| \le D_C$$

gilt, dann ein Überwachungssignal erzeugt wird, das anzeigt, dass entweder die zweite Kondensatordurchführung (2b) nicht in ordnungsgemäßem Zustand ist oder die beiden anderen Kondensatordurchführungen (2a, 2c) nicht in ordnungsgemäßem Zustand sind und einen gleichartigen Fehler haben;
- falls die Verlustfaktorvergleiche ergeben, dass

$$\left|\Delta D_a(t_2)\right| \le D_A \text{ und } \left|\Delta D_b(t_2)\right| > D_B \text{ und } \left|\Delta D_c(t_2)\right| > D_C$$

gilt, dann ein Überwachungssignal erzeugt wird, das anzeigt, dass entweder die dritte Kondensatordurchführung (2c) nicht in ordnungsgemäßem Zustand ist oder die beiden anderen Kondensatordurchführungen (2b, 2a) nicht in ordnungsgemäßem Zustand sind und einen gleichartigen Fehler haben;
- falls die Verlustfaktorvergleiche ergeben, dass

$$\left|\Delta D_a(t_2)\right| > D_A \text{ und } \left|\Delta D_b(t_2)\right| \le D_B \text{ und } \left|\Delta D_c(t_2)\right| > D_C$$

gilt, dann ein Überwachungssignal erzeugt wird, das anzeigt, dass entweder die erste Kondensatordurchführung (2a) nicht in ordnungsgemäßem Zustand ist oder die beiden anderen Kondensatordurchführungen (2c, 2b) nicht in ordnungsgemäßem Zustand sind und einen gleichartigen Fehler haben.

**8.** Verfahren nach dem vorigen Anspruch, wobei

- andernfalls ein Überwachungssignal erzeugt wird, das anzeigt, dass entweder alle drei Kondensatordurchführungen (2a, 2b, 2c) nicht in ordnungsgemäßem Zustand sind oder zwei Kondensatordurchführungen nicht in ordnungsgemäßem Zustand sind und keinen gleichartigen Fehler haben.

**9.** Verfahren nach einem der vorigen Ansprüche, wobei

- zu einem vorbestimmten dritten Zeitpunkt (t3), der nach dem zweiten Zeitpunkt (t2) liegt, für jede dieser Phasen (A, B, C)

  • für eine Referenzspannung ein entsprechender dritter Referenzspannungszeiger (Ra(t3), Rb(t3), Rc(t3)) ermittelt wird;
  • die Belagspannung erfasst und ein entsprechender dritter Belagspannungszeiger (Va(t3), Vb(t3), Vc(t3)) ermittelt wird;
  • der zweite Referenzspannungszeiger durch den dritten Referenzspannungszeiger und der zweite Belagspannungszeiger durch den dritten Belagspannungszeiger ersetzt wird;

- für jede dieser Kondensatordurchführungen (2a, 2b, 2c)

  • das Berechnen und Vergleichen der Verlustfaktoränderung (ΔDa, ΔDb, ΔDc) wiederholt wird;

- ein Überwachungssignal in Abhängigkeit von den Ergebnissen dieser Verlustfaktorvergleiche erzeugt wird.

10. Verfahren nach dem vorigen Anspruch, wobei

   - vor jedem Ersetzen des zweiten Referenzspannungszeigers und Belagspannungszeigers

      • der erste Referenzspannungszeiger durch den zweiten Referenzspannungszeiger und der erste Belagspannungszeiger durch den zweiten Belagspannungszeiger ersetzt wird.

11. Verfahren nach einem der vorigen Ansprüche, wobei

   - zu wenigstens einem vorbestimmten späteren Zeitpunkt (tn), der nach dem zweiten Zeitpunkt (t2) liegt, für jede dieser Phasen (A, B, C)

      • für eine Referenzspannung ein entsprechender späterer Referenzspannungszeiger (Ra(tn), Rb(tn), Rc(tn)) ermittelt wird;
      • die Belagspannung erfasst und ein entsprechender späterer Belagspannungszeiger (Va(tn), Vb(tn), Vc(tn)) ermittelt wird;

   - für jede dieser Kondensatordurchführungen (2a, 2b, 2c)

      • das Berechnen der Verlustfaktoränderung (ΔDa, ΔDb, ΔDc) zusätzlich von den jeweiligen späteren Netzspannungszeigern und Belagspannungszeigern abhängt.

12. Verfahren nach einem der vorigen Ansprüche, wobei

   - zu wenigstens einem vorbestimmten späteren Zeitpunkt (tn), der nach dem zweiten Zeitpunkt (t2) liegt, für jede dieser Phasen (A, B, C)

      • ein späterer Referenzspannungszeiger (Ra(tn), Rb(tn), Rc(tn)) ermittelt wird;
      • die Belagspannung erfasst und ein entsprechender späterer Belagspannungszeiger (Va(tn), Vb(tn), Vc(tn)) ermittelt wird;

   - für jede dieser Kondensatordurchführungen (2a, 2b, 2c)

      • eine Verlustfaktoränderung (ΔDa, ΔDb, ΔDc) in Abhängigkeit von den jeweiligen ersten, zweiten und späteren Referenzspannungszeigern und Belagspannungszeigern sowie von den ersten, zweiten und späteren Referenzspannungszeigern und Belagspannungszeigern der jeweils benachbarten Kondensatordurchführung (2b, 2c, 2a) berechnet wird;
      • die Verlustfaktoränderung mit einem Toleranzwert (DA, DB, DC) verglichen wird;

   - ein Überwachungssignal in Abhängigkeit von den Ergebnissen dieser Verlustfaktorvergleiche erzeugt wird.

13. Verfahren nach einem der 2 vorigen Ansprüche, wobei

   - die Verlustfaktoränderung der ersten Kondensatordurchführung (2a) gemäß folgender Formel

$$\Delta D_a(t_n) = \sum_{i=2}^{n} \left\{ g_{ai}\left[\theta_{ab}(t_i) - \theta_{ab}(t_{i-1})\right] \right\}$$

mit

$$\theta_{ab}(t_j) = \arccos \frac{\underline{V}_a(t_j) \cdot \underline{V}_b(t_j)}{\left|\underline{V}_a(t_j)\right| \cdot \left|\underline{V}_b(t_j)\right|} - \arccos \frac{\underline{R}_a(t_j) \cdot \underline{R}_b(t_j)}{\left|\underline{R}_a(t_j)\right| \cdot \left|\underline{R}_b(t_j)\right|} \quad , j = 1, \ldots, n$$

$$\sum_{i=2}^{n} g_{ai} = 1$$

berechnet wird; und/oder
- die Verlustfaktoränderung der zweiten Kondensatordurchführung (2b) gemäß folgender Formel

$$\Delta D_b(t_n) = \sum_{i=2}^{n} \left\{ g_{bi}[\theta_{bc}(t_i) - \theta_{bc}(t_{i-1})] \right\}$$

mit

$$\theta_{bc}(t_j) = \arccos \frac{\underline{V}_b(t_j) \cdot \underline{V}_c(t_j)}{\left|\underline{V}_b(t_j)\right| \cdot \left|\underline{V}_c(t_j)\right|} - \arccos \frac{\underline{R}_b(t_j) \cdot \underline{R}_c(t_j)}{\left|\underline{R}_b(t_j)\right| \cdot \left|\underline{R}_c(t_j)\right|} \quad, j = 1, ..., n$$

$$\sum_{i=2}^{n} g_{bi} = 1$$

berechnet wird; und/oder
- die Verlustfaktoränderung der dritten Kondensatordurchführung (2c) gemäß folgender Formel

$$\Delta D_c(t_n) = \sum_{i=2}^{n} \left\{ g_{ci}[\theta_{ca}(t_i) - \theta_{ca}(t_{i-1})] \right\}$$

mit

$$\theta_{ca}(t_j) = \arccos \frac{\underline{V}_c(t_j) \cdot \underline{V}_a(t_j)}{\left|\underline{V}_c(t_j)\right| \cdot \left|\underline{V}_a(t_j)\right|} - \arccos \frac{\underline{R}_c(t_j) \cdot \underline{R}_a(t_j)}{\left|\underline{R}_c(t_j)\right| \cdot \left|\underline{R}_a(t_j)\right|} \quad, j = 1, ..., n$$

$$\sum_{i=2}^{n} g_{ci} = 1$$

berechnet wird; wobei
- $n > 2$ die Anzahl der Zeitpunkte ist;
- t1, t2 der erste und zweite Zeitpunkt und t3, ..., tn die späteren Zeitpunkte sind;
- gai, gbi, gci i-te Gewichtungsfaktoren für die erste, zweite und dritte Kondensatordurchführung sind.

14. Verfahren nach dem vorigen Anspruch, wobei

- jeder Gewichtungsfaktor vom Alter des jeweiligen Zeitpunkts antiton abhängt; und/oder
- für die Gewichtungsfaktoren

$$g_{ai-1} \leq g_{ai} \text{ und/oder } g_{bi-1} \leq g_{bi} \text{ und/oder } g_{ci-1} \leq g_{ci} \text{ für i = 2, ..., n}$$

gilt.

**15.** Verfahren nach einem der vorigen Ansprüche, wobei

- zwischen dem Ermitteln der ersten Referenzspannungszeiger und dem Ermitteln der ersten Belagspannungszeiger

  • die Größen der ersten Referenzspannungszeiger untereinander verglichen werden,
  • das Ermitteln der ersten Belagspannungszeiger erfolgt, falls diese Größenvergleiche ergeben, dass diese Größen nicht mehr als ein vorbestimmtes Maß voneinander abweichen;

und/oder
- zwischen dem Ermitteln der zweiten Referenzspannungszeiger und dem Ermitteln der zweiten Belagspannungszeiger

  • die Größen der zweiten Referenzspannungszeiger untereinander verglichen werden,
  • das Ermitteln der zweiten Belagspannungszeiger erfolgt, falls diese Größenvergleiche ergeben, dass diese Größen nicht mehr als ein vorbestimmtes Maß voneinander abweichen.

**16.** Verfahren nach einem der vorigen Ansprüche, wobei

- zwischen dem Ermitteln der ersten Referenzspannungszeiger und dem Ermitteln der ersten Belagspannungszeiger

  • die Phasenwinkel der ersten Referenzspannungszeiger untereinander verglichen werden,
  • das Ermitteln der ersten Belagspannungszeiger erfolgt, falls diese Winkelvergleiche ergeben, dass diese Phasenwinkel nicht mehr als ein vorbestimmtes Maß voneinander abweichen;

- zwischen dem Ermitteln der zweiten Referenzspannungszeiger und dem Ermitteln der zweiten Belagspannungszeiger

  • die Phasenwinkel der zweiten Referenzspannungszeiger untereinander verglichen werden,
  • das Ermitteln der zweiten Belagspannungszeiger erfolgt, falls diese Winkelvergleiche ergeben, dass diese Phasenwinkel nicht mehr als ein vorbestimmtes Maß voneinander abweichen.

**17.** Vorrichtung (1) zum Überwachen von Kondensatordurchführungen (2a, 2b, 2c) für ein Wechselstromnetz, wobei

- das Wechselstromnetz eine erste, zweite und dritte Phase (A, B, C) hat und umfasst

  • eine erste Netzleitung (5a), der die erste Phase (A) und eine erste Kondensatordurchführung (2a) zugeordnet sind und an der eine erste Netzspannung anliegt,
  • eine zweite Netzleitung (5b), der die zweite Phase (B) und eine zweite Kondensatordurchführung (2b) zugeordnet sind und an der eine zweite Netzspannung anliegt,
  • eine dritte Netzleitung (5c), der die dritte Phase (C) und eine dritte Kondensatordurchführung (2c) zugeordnet sind und an der eine dritte Netzspannung anliegt;

- jede dieser Kondensatordurchführungen (2a, 2b, 2c) umfasst

  • einen Leiter (4), der mit der zugeordneten Netzleitung (5a, 5b, 5c) verbunden ist;
  • einen elektrisch leitfähigen Belag (3), der diesen Leiter (4) umgibt;

- die Vorrichtung umfasst:

  • einen ersten Spannungswandler (9a), der mit der ersten Netzleitung (5a) verbunden werden kann;
  • einen zweiten Spannungswandler (9b), der mit der zweiten Netzleitung (5b) verbunden werden kann;

• einen dritten Spannungswandler (9c), der mit der dritten Netzleitung (5c) verbunden werden kann;
• einen ersten Messadapter (6a), der mit dem Belag (3) der ersten Kondensatordurchführung (2a) verbunden werden kann;
• einen zweiten Messadapter (6b), der mit dem Belag (3) der zweiten Kondensatordurchführung (2b) verbunden werden kann;
• einen dritten Messadapter (6c), der mit dem Belag (3) der dritten Kondensatordurchführung (2c) verbunden werden kann;
• eine Messeinrichtung (7), die an die Messadapter (6a, 6b, 6c) gekoppelt ist;
• eine Auswerteeinrichtung (8), die an die Spannungswandler (9a, 9b, 9c) und die Messeinrichtung (7) gekoppelt ist;

- jeder dieser Spannungswandler (9a, 9b, 9c) für die jeweilige Phase (A, B, C) die Netzspannung erfassen kann;
- die Messeinrichtung (7) für jede dieser Phasen (A, B, C) mithilfe des jeweiligen Messadapters (6a, 6b, 6c) eine Belagspannung, die zwischen dem jeweiligen Belag (3) und Massepotenzial (13) anliegt, erfassen kann;
- die Auswerteeinrichtung (8) derart ausgebildet ist, dass sie zu einem vorbestimmten ersten Zeitpunkt (t1) für jede dieser Phasen (A, B, C)

• mithilfe des jeweiligen Spannungswandlers (9a, 9b, 9c) die Netzspannung erfassen und einen entsprechenden ersten Netzspannungszeiger (Ua(t1), Ub(t1), Uc(t1)) ermitteln kann;
• mithilfe der Messeinrichtung (7) die Belagspannung erfassen und einen entsprechenden ersten Belagspannungszeiger (Va(t1), Mb(t1), Vc(t1)) ermitteln kann;

- die Auswerteeinrichtung (8) derart ausgebildet ist, dass sie zu einem vorbestimmten zweiten Zeitpunkt (t2), der nach dem ersten Zeitpunkt (t1) liegt, für jede dieser Phasen (A, B, C)

• mithilfe des jeweiligen Spannungswandlers (9a, 9b, 9c) die Netzspannung erfassen und einen entsprechenden zweiten Netzspannungszeiger (Ua(t2), Ub(t2), Uc(t2)) ermitteln kann;
• mithilfe der Messeinrichtung (7) die Belagspannung erfassen und einen entsprechenden zweiten Belagspannungszeiger (Va(t2), Vb(t2), Vc(t2)) ermitteln kann;

**dadurch gekennzeichnet, dass**
- die Auswerteeinrichtung (8) derart ausgebildet ist, dass sie für jede dieser Kondensatordurchführungen (2a, 2b, 2c)

• eine Verlustfaktoränderung (ΔDa, ΔDb, ΔDc) in Abhängigkeit von den jeweiligen ersten und zweiten Netzspannungszeigern und Belagspannungszeigern sowie von den ersten und zweiten Netzspannungszeigern und Belagspannungszeigern der jeweils benachbarten Kondensatordurchführung (2b, 2c, 2a) berechnen kann;
• die Verlustfaktoränderung mit einem Toleranzwert (DA, DB, DC) vergleichen kann;

- die Auswerteeinrichtung (8) derart ausgebildet ist, dass sie ein Überwachungssignal in Abhängigkeit von den Ergebnissen dieser Verlustfaktorvergleiche erzeugen kann; wobei
- die Verlustfaktoränderung der ersten Kondensatordurchführung (2a) gemäß folgender Formel

$$\Delta D_a(t_2) = \theta_{ab}(t_2) - \theta_{ab}(t_1)$$

mit

$$\theta_{ab}(t_j) = \left( \arccos \frac{\underline{V}_a(t_j) \cdot \underline{V}_b(t_j)}{\left|\underline{V}_a(t_j)\right| \cdot \left|\underline{V}_b(t_j)\right|} - \arccos \frac{\underline{R}_a(t_j) \cdot \underline{R}_b(t_j)}{\left|\underline{R}_a(t_j)\right| \cdot \left|\underline{R}_b(t_j)\right|} \right), j = 1, 2$$

berechnet wird; und/oder
- die Verlustfaktoränderung der zweiten Kondensatordurchführung (2b) gemäß folgender Formel

$$\Delta D_b(t_2) = \theta_{bc}(t_2) - \theta_{bc}(t_1)$$

mit

$$\theta_{bc}(t_j) = \left( \arccos \frac{\underline{V}_b(t_j) \cdot \underline{V}_c(t_j)}{\left| \underline{V}_b(t_j) \right| \cdot \left| \underline{V}_c(t_j) \right|} - \arccos \frac{\underline{R}_b(t_j) \cdot \underline{R}_c(t_j)}{\left| \underline{R}_b(t_j) \right| \cdot \left| \underline{R}_c(t_j) \right|} \right), j = 1, 2$$

berechnet wird; und/oder
- die Verlustfaktoränderung der dritten Kondensatordurchführung (2c) gemäß folgender Formel

$$\Delta D_c(t_2) = \theta_{ca}(t_2) - \theta_{ca}(t_1)$$

mit

$$\theta_{ca}(t_j) = \left( \arccos \frac{\underline{V}_c(t_j) \cdot \underline{V}_a(t_j)}{\left| \underline{V}_c(t_j) \right| \cdot \left| \underline{V}_a(t_j) \right|} - \arccos \frac{\underline{R}_c(t_j) \cdot \underline{R}_a(t_j)}{\left| \underline{R}_c(t_j) \right| \cdot \left| \underline{R}_a(t_j) \right|} \right), j = 1, 2$$

berechnet wird; wobei
- Ra(t1), Rb(t1), Rc(t1) die ersten Referenzspannungszeiger der ersten, zweiten und dritten Phase sind;
- Va(t1), Vb(t1), Vc(t1) die ersten Belagspannungszeiger der ersten, zweiten und dritten Phase sind;
- Ra(t2), Rb(t2), Rc(t2) die zweiten Referenzspannungszeiger der ersten, zweiten und dritten Phase sind;
- Va(t2), Vb(t2), Vc(t2) die zweiten Belagspannungszeiger der ersten, zweiten und dritten Phase sind.


**Claims**

1. Method of monitoring capacitor bushings (2a, 2b, 2c) for an alternating current mains, wherein

   - the alternating current mains has a first, second and third phase (A, B, C) and comprises

     • a first mains line (5a), with which the first phase (A) and a first capacitor bushing (2a) are associated and at which a first mains voltage is present,
     • a second mains line (5b), with which the second phase (B) and a second capacitor bushing (2b) are associated and at which a second mains voltage is present,
     • a third mains line (5c), with which the third phase (C) and a third capacitor bushing (2c) are associated and at which a third mains voltage is present;

   - each of these capacitor bushings (2a, 2b, 2c) comprises

     • a conductor (4) connected with the associated mains line (5a, 5b, 5c);
     • an electrically conductive foil (3) surrounding this conductor (4);

   - at a predetermined first instant (t1), for each of these phases (A, B, C)

     • a corresponding first reference voltage phasor (Ra(t1), Rb(t1), Rc(t1)) is determined for a first reference voltage;
     • a foil voltage present between the respective foil (3) and ground potential (13) is detected and a corresponding first foil voltage phasor (Va(t1), Vb(t1), Vc(t1)) is determined;

   - at a predetermined second instant (t2) lying after the first instant (t1), for each of these phases (A, B, C)

• a corresponding second reference voltage phasor (Ra(t1), Rb(t1), Rc(t1)) is determined for a second reference voltage;
• the foil voltage is detected and a corresponding second foil voltage phasor ($\underline{V}$a(t2), $\underline{V}$b(t2), $\underline{V}$c(t2)) is determined;

**characterised in that**
- for each of these capacitor bushings (2a, 2b, 2c)

• a loss factor change (ΔDa, ΔDb, ΔDc) is calculated in dependence on the respective first and second reference voltage phasors and foil voltage phasors as well as on the first and second reference voltage phasors and foil voltage phasors of the respectively adjacent capacitive bushing (2b, 2c, 2a);

- the loss factor change of the first capacitor bushing (2a) is calculated in accordance with the following equation

$$\Delta D_a(t_2) = \theta_{ab}(t_2) - \theta_{ab}(t_1)$$

wherein

$$\theta_{ab}(t_j) = \left( \arccos \frac{\underline{V}_a(t_j) \cdot \underline{V}_b(t_j)}{\left|\underline{V}_a(t_j)\right| \cdot \left|\underline{V}_b(t_j)\right|} - \arccos \frac{\underline{R}_a(t_j) \cdot \underline{R}_b(t_j)}{\left|\underline{R}_a(t_j)\right| \cdot \left|\underline{R}_b(t_j)\right|} \right), j = 1, 2;$$

and/or
- the loss factor change of the second capacitor bushing (2b) is calculated in accordance with the following equation

$$\Delta D_b(t_2) = \theta_{bc}(t_2) - \theta_{bc}(t_1)$$

wherein

$$\theta_{bc}(t_j) = \left( \arccos \frac{\underline{V}_b(t_j) \cdot \underline{V}_c(t_j)}{\left|\underline{V}_b(t_j)\right| \cdot \left|\underline{V}_c(t_j)\right|} - \arccos \frac{\underline{R}_b(t_j) \cdot \underline{R}_c(t_j)}{\left|\underline{R}_b(t_j)\right| \cdot \left|\underline{R}_c(t_j)\right|} \right), j = 1, 2;$$

and/or
- the loss factor change of the third capacitor bushing (2c) is calculated in accordance with the following equation

$$\Delta D_c(t_2) = \theta_{ca}(t_2) - \theta_{ca}(t_1)$$

wherein

$$\theta_{ca}(t_j) = \left( \arccos \frac{\underline{V}_c(t_j) \cdot \underline{V}_a(t_j)}{\left|\underline{V}_c(t_j)\right| \cdot \left|\underline{V}_a(t_j)\right|} - \arccos \frac{\underline{R}_c(t_j) \cdot \underline{R}_a(t_j)}{\left|\underline{R}_c(t_j)\right| \cdot \left|\underline{R}_a(t_j)\right|} \right), j = 1, 2$$

wherein;
- Ra(t1), Rb(t1), Rc(t1) are the first reference voltage phasors of the first, second and third phase;
- Va(t1), Vb(t1), Vc(t1) are the first foil voltage phasors of the first, second and third phase;
- Ra(t2), Rb(t2), Rc(t2) are the second reference voltage phasors of the first, second and third phase;

- Va(t2), Vb(t2), Vc(t2) are the second foil voltage phasors of the first, second and third phase.

     • the loss factor change is compared with a tolerance value (DA, DB, DC);

- a monitoring signal is generated in dependence on the results of these loss factor comparisons.

**2.** Method according to the preceding claim, wherein

- each reference voltage is the respective mains voltage (Ua(t1), Ua(t2), Ub(t1), Ub(t2), Uc(t1), Uc(t2)).

**3.** Method according to claim 1, wherein

- a first parallel capacitor bushing (2a') is associated with the first mains line (5a);
- a second parallel capacitor bushing (2b') is associated with the second mains line (5b);
- a third parallel capacitor bushing (2c') is associated with the third mains line (5c);
- each of these parallel capacitor bushings (2a', 2b', 2c') comprises

     • a conductor (4) connected with the associated mains line (5a, 5b, 5c),
     • an electrically conductive foil (3) surrounding this conductor (4);

- for each of these phases (A, B, C)

     • the first and second reference voltages are first and second foil voltages (Va'(t1), Vb'(t1), Vc'(t1), Va'(t2), Vb'(t2), Vc'(t2)) respectively present at the first instant and the second instant between the foil (3) and ground potential (13) of the respective parallel capacitor bushing.

**4.** Method according to claim 1 or one of the preceding claims, wherein

- for each of these phases (A, B,C)

     • the reference voltage is a constant voltage for which a corresponding constant voltage phasor is predetermined.

**5.** Method according to the preceding claim, wherein

- the magnitude of each constant voltage phasor is equal to a rated voltage value of the alternating current mains;
- for the first phase (A) the phase angle of the first and second constant voltage phasors ($\underline{R}a(t1)$, $\underline{R}a(t2)$) is 0°;
- for the second phase (B) the phase angle of the first and second constant voltage phasors ($\underline{R}b(t1)$, $\underline{R}b(t2)$) is 120°;
- for the third phase (C) the phase angle of the first and second constant voltage phasors ($\underline{R}c(t1)$, $\underline{R}c(t2)$) is 240°.

**6.** Method according to any one of the preceding claims, wherein

- tolerance values DA > 0, DB > 0, DC > 0 are determined for the loss factor comparisons;
- if the loss factor comparisons have the result that

$$\left|\Delta D_a(t_2)\right| \le D_A \text{ and } \left|\Delta D_b(t_2)\right| \le D_B \text{ and } \left|\Delta D_c(t_2)\right| \le D_C$$

then a monitoring signal is generated which indicates that the capacitor bushings (2a, 2b, 2c) are in a state of proper order.

**7.** Method according to any one of the preceding claims, wherein

- tolerance values DA > 0, DB > 0, DC > 0 are determined for the loss factor comparisons;
- if the loss factor comparisons have the result that

$$\left|\Delta D_a(t_2)\right| > D_A \text{ and } \left|\Delta D_b(t_2)\right| > D_B \text{ and } \left|\Delta D_c(t_2)\right| \le D_C$$

then a monitoring signal is generated which indicates that either the second capacitor bushing (2b) is not in a state of proper order or the two other capacitor bushings (2a, 2c) are not in a state of proper order and have a fault of the same kind;
- if the loss factor comparisons have the result that

$$\left|\Delta D_a(t_2)\right| \le D_A \text{ and } \left|\Delta D_b(t_2)\right| > D_B \text{ and } \left|\Delta D_c(t_2)\right| > D_C$$

then a monitoring signal is generated which indicates that either the third capacitor bushing (2c) is not in a state of proper order or the two other capacitor bushings (2b, 2a) are not in a state of proper order and have a fault of the same kind;
- if the loss factor comparisons have the result that

$$\left|\Delta D_a(t_2)\right| > D_A \text{ and } \left|\Delta D_b(t_2)\right| \le D_B \text{ and } \left|\Delta D_c(t_2)\right| > D_C$$

then a monitoring signal is generated which indicates that either the first capacitor bushing (2a) is not in a state of proper order or the two other capacitor bushings (2c, 2b) are not in a state of proper order and have a fault of the same kind.

**8.** Method according to the preceding claim, wherein

- otherwise a monitoring signal is generated which indicates that either all three capacitor bushings (2a, 2b, 2c) are not in a state of proper order or two capacitor bushings are not in a state of proper order and do not have a fault of the same kind.

**9.** Method according to any one of the preceding claims, wherein

- at a predetermined third instant (t3) lying after the second instant (t2), for each of these phases (A, B, C)

• a corresponding third reference voltage phasor Ra(t3), Rb(t3), Rc(t3) is determined for a reference voltage;
• the foil voltage is detected and a corresponding third foil voltage phasor Va(t3), Vb(t3), Vc(t3) is determined;
• the second reference voltage phasor is replaced by the third reference voltage phasor and the second foil voltage phasor is replaced by the third foil voltage phasor;

- for each of these capacitor bushings (2a, 2b, 2c)

• the calculation and comparison of the loss factor change (ΔDa, ΔDb, ΔDc) are repeated;

- a monitoring signal is generated in dependence on the results of these loss factor comparisons.

**10.** Method according to the preceding claim, wherein

- before each replacement of the second reference voltage phasor and foil voltage phasor

• the first reference voltage phasor is replaced by the second reference voltage phasor and the first foil voltage phasor is replaced by the second foil voltage phasor.

**11.** Method according to any one of the preceding claims, wherein

- at at least one predetermined later instant (tn) lying after the second instant (t2), for each of these phases (A, B, C)

• a corresponding later reference voltage phasor (Ra(tn), Rb(tn), Rc(tn)) is determined for a reference voltage;
• the foil voltage is detected and a corresponding later foil voltage phasor (Va(tn), Vb(tn), Vc(tn)) is determined;

- for each of these capacitor bushings (2a, 2b, 2c)

• the calculation of the loss factor change (ΔDa, ΔDb, ΔDc) additionally depends on the respective later mains voltage phasors and foil voltage phasors.

**12.** Method according to any one of the preceding claims, wherein

- at at least one predetermined later instant (tn) lying after the second instant (t2), for each of these phases (A, B, C)

• a later reference voltage phasor (Ra(tn), Rb(tn), Rc(tn)) is determined;
• the foil voltage is detected and a corresponding later foil voltage phasor (Va(tn), Vb(tn), Vc(tn)) is determined;

- for each of these capacitor bushings (2a, 2b, 2c)

• a loss factor change (ΔDa, ΔDb, ΔDc) is calculated in dependence on the respective first, second and later reference voltage phasors and foil voltage phasors as well as on the first, second and later reference voltage phasors and foil voltage phasors of the respectively adjacent capacitor bushing (2b, 2c, 2a);
• the loss factor change is compared with a tolerance value (DA, DB, DC);

- a monitoring signal is generated in dependence on the results of these loss factor comparisons.

**13.** Method according to one of the two preceding claims, wherein

- the loss factor change of the first capacitor bushing (2a) is calculated in accordance with the following equation

$$\Delta D_a(t_n) = \sum_{i=2}^{n} \left\{ g_{ai} [\theta_{ab}(t_i) - \theta_{ab}(t_{i-1})] \right\}$$

wherein

$$\theta_{ab}(t_j) = \arccos \frac{\underline{V}_a(t_j) \cdot \underline{V}_b(t_j)}{\left|\underline{V}_a(t_j)\right| \cdot \left|\underline{V}_b(t_j)\right|} - \arccos \frac{\underline{R}_a(t_j) \cdot \underline{R}_b(t_j)}{\left|\underline{R}_a(t_j)\right| \cdot \left|\underline{R}_b(t_j)\right|} \quad , j = 1, \ldots, n$$

$$\sum_{i=2}^{n} g_{ai} = 1 ;$$

and/or
- the loss factor change of the second capacitor bushing (2b) is calculated in accordance with the following equation

$$\Delta D_b(t_n) = \sum_{i=2}^{n} \left\{ g_{bi} [\theta_{bc}(t_i) - \theta_{bc}(t_{i-1})] \right\}$$

wherein

$$\theta_{bc}(t_j) = \arccos \frac{\underline{V}_b(t_j) \cdot \underline{V}_c(t_j)}{\left|\underline{V}_b(t_j)\right| \cdot \left|\underline{V}_c(t_j)\right|} - \arccos \frac{\underline{R}_b(t_j) \cdot \underline{R}_c(t_j)}{\left|\underline{R}_b(t_j)\right| \cdot \left|\underline{R}_c(t_j)\right|} \quad , j = 1, ..., n$$

$$\sum_{i=2}^{n} g_{bi} = 1$$

and/or
- the loss factor change of the third capacitor bushing (2c) is calculated in accordance with the following equation

$$\Delta D_c(t_n) = \sum_{i=2}^{n} \left\{ g_{ci}[\theta_{ca}(t_i) - \theta_{ca}(t_{i-1})] \right\}$$

wherein

$$\theta_{ca}(t_j) = \arccos \frac{\underline{V}_c(t_j) \cdot \underline{V}_a(t_j)}{\left|\underline{V}_c(t_j)\right| \cdot \left|\underline{V}_a(t_j)\right|} - \arccos \frac{\underline{R}_c(t_j) \cdot \underline{R}_a(t_j)}{\left|\underline{R}_c(t_j)\right| \cdot \left|\underline{R}_a(t_j)\right|} \quad , j = 1, ..., n$$

$$\sum_{i=2}^{n} g_{ci} = 1 ;$$

wherein;
- n > 2 is the number of the instants;
- t1, t2 are the first and second instants and t3, ..., tn are the later instants;
- gai, gbi, gci are ith weighting factors for the first, second and third capacitor bushings.

**14.** Method according to the preceding claim, wherein

- each weighting factor antitonically depends on the age of the respective instant; and/or
- there applies for the weighting factors

$$g_{ai-1} \leq g_{ai} \text{ and/or } g_{bi-1} \leq g_{bi} \text{ and/or } g_{ci-1} \leq g_{ci} \text{ for i = 2, ..., n.}$$

**15.** Method according to any one of the preceding claims, wherein

- between determination of the first reference voltage phasors and determination of the first foil voltage phasors

  • the magnitudes of the first reference voltage phasors are compared with one another,
  • determination of the first foil voltage phasors is carried out if these magnitude comparisons have the result that these magnitudes do not differ from one another by more than a predetermined amount;

and/or
- between determination of the second reference voltage phasors and determination of the second foil voltage phasors

  • the magnitudes of the second reference voltage phasors are compared with one another,
  • determination of the second foil voltage phasors is carried out if these magnitude comparisons have the result that these magnitudes do not differ from one another by more than a predetermined amount.

**16.** Method according to any one of the preceding claims, wherein

- between determination of the first reference voltage phasors and determination of the first foil voltage phasors

  • the phase angles of the first reference voltage phasors are compared with one another,
  • determination of the first foil voltage phasors is carried out if these angle comparisons have the result that these phase angles do not differ from one another by more than a predetermined amount;

- between determination of the second reference voltage phasors and determination of the second foil voltage phasors

  • the phase angles of the second reference voltage phasors are compared with one another,
  • determination of the second foil voltage phasors is carried out if these angle comparisons have the result that these phase angles do not differ from one another by more than a predetermined amount.

**17.** Device (1) for monitoring capacitor bushings (2a, 2b, 2c) for an alternating current mains, wherein

- the alternating current mains has a first, second and third phase (A, B, C) and comprises

  • a first mains line (5a), with which the first phase (A) and a first capacitor bushing (2a) are associated and at which a first mains voltage is present,
  • a second mains line (5b), with which the second phase (B) and a second capacitor bushing (2b) are associated and at which a second mains voltage is present,
  • a third mains line (5c), with which the third phase (C) and a third capacitor bushing (2c) are associated and at which a third mains voltage is present;

- each of these capacitor bushings (2a, 2b, 2c) comprises

  • a conductor (4) connected with the associated mains line (5a, 5b, 5c);
  • an electrically conductive foil (3) surrounding this conductor (4);

- the device comprises:

  • a first voltage converter (9a) which can be connected with the first mains line (5a);
  • a second voltage converter (9b) which can be connected with the second mains line (5b);
  • a third voltage converter (9c) which can be connected with the third mains line (5c);
  • a first measuring adapter (6a) which can be connected with the foil (3) of the first capacitor bushing (2a);
  • a second measuring adapter (6b) which can be connected with the foil (3) of the second capacitor bushing (2b);
  • a third measuring adapter (6c) which can be connected with the foil (3) of the third capacitor bushing (2c);
  • a measuring device (7) coupled to the measuring adapters (6a, 6b, 6c);
  • an evaluating device (8) coupled to the voltage converters (9a, 9b, 9c) and the measuring device (7);

- each of these voltage converters (9a, 9b, 9c) for the respective phase (A, B, C) can detect the mains voltage;
- the measuring device (7) for each of these phases (A, B, C) can detect, with the help of the respective measuring adapter (6a, 6b, 6c), a foil voltage present between the respective foil (3) and ground potential (13);
- the evaluating device (8) is so constructed that at a predetermined first instant (t1), for each of these phases (A, B, C) it

  • can detect the mains voltage with the help of the respective voltage converter (9a, 9b, 9c) and can determine a corresponding first mains voltage phasor ($\underline{U}a(t1)$, $\underline{U}b(t1)$, $\underline{U}c(t1)$);
  • can detect the foil voltage with the help of the measuring device (7) and can determine a corresponding first foil voltage phasor ($\underline{V}a(t1)$, $\underline{V}b(t1)$, $\underline{V}c(t1)$);

- the evaluating device (8) is so constructed that at a predetermined second instant (t2) lying after the first instant (t1), for each of these phases (A, B, C) it

  • can detect the mains voltage with the help of the respective voltage converter (9a, 9b, 9c) and can determine a corresponding second mains voltage phasor ($\underline{U}$a(t2), $\underline{U}$b(t2), $\underline{U}$c(t2));
• can detect the foil voltage with the help of the measuring device (7) and can determine a corresponding second foil voltage phasor ($\underline{V}$a(t2), $\underline{V}$b(t2), $\underline{V}$c(t2));

**characterised in that**
- the evaluating device (8) is so constructed that for each of these capacitor bushings (2a, 2b, 2c) it

• can calculate a loss factor change ($\Delta$Da, $\Delta$Db, $\Delta$Dc) in dependence on the respective first and second mains voltage phasors and foil voltage phasors as well as on the first and second mains voltage phasors and foil voltage phasors of the respectively adjacent capacitor bushing (2b, 2c, 2a);
• can compare the loss factor change with a tolerance value (DA,DB, DC);

- the evaluating device (8) is so constructed that it can generate a monitoring signal in dependence on the results of these loss factor comparisons; wherein
- the loss factor change of the first capacitor bushing (2a) is calculated in accordance with the following equation

$$\Delta D_a(t_2) = \theta_{ab}(t_2) - \theta_{ab}(t_1)$$

wherein

$$\theta_{ab}(t_j) = \left( \arccos \frac{\underline{V}_a(t_j) \cdot \underline{V}_b(t_j)}{\left|\underline{V}_a(t_j)\right| \cdot \left|\underline{V}_b(t_j)\right|} - \arccos \frac{\underline{R}_a(t_j) \cdot \underline{R}_b(t_j)}{\left|\underline{R}_a(t_j)\right| \cdot \left|\underline{R}_b(t_j)\right|} \right), j = 1, 2;$$

and/or
- the loss factor change of the second capacitor bushing (2b) is calculated in accordance with the following equation

$$\Delta D_b(t_2) = \theta_{bc}(t_2) - \theta_{bc}(t_1)$$

wherein

$$\theta_{bc}(t_j) = \left( \arccos \frac{\underline{V}_b(t_j) \cdot \underline{V}_c(t_j)}{\left|\underline{V}_b(t_j)\right| \cdot \left|\underline{V}_c(t_j)\right|} - \arccos \frac{\underline{R}_b(t_j) \cdot \underline{R}_c(t_j)}{\left|\underline{R}_b(t_j)\right| \cdot \left|\underline{R}_c(t_j)\right|} \right), j = 1, 2;$$

and/or
- the loss factor change of the third capacitor bushing (2c) is calculated in accordance with the following equation

$$\Delta D_c(t_2) = \theta_{ca}(t_2) - \theta_{ca}(t_1)$$

wherein

$$\theta_{ca}(t_j) = \left( \arccos \frac{\underline{V}_c(t_j) \cdot \underline{V}_a(t_j)}{\left|\underline{V}_c(t_j)\right| \cdot \left|\underline{V}_a(t_j)\right|} - \arccos \frac{\underline{R}_c(t_j) \cdot \underline{R}_a(t_j)}{\left|\underline{R}_c(t_j)\right| \cdot \left|\underline{R}_a(t_j)\right|} \right), j = 1, 2$$

wherein;
- Ra(t1), Rb(t1), Rc(t1) are the first reference voltage phasors of the first, second and third phase;

- Va(t1), Vb(t1), Vc(t1) are the first foil voltage phasors of the first, second and third phase;
- Ra(t2), Rb(t2), Rc(t2) are the second reference voltage phasors of the first, second and third phase;
- Va(t2), Vb(t2), Vc(t2) are the second foil voltage phasors of the first, second and third phase.

**Revendications**

1. Procédé de surveillance de traversées de condensateur (2a, 2b, 2c) destiné à un réseau à courant alternatif,

    - le réseau à courant alternatif comportant des première, deuxième et troisième phases (A, B, C) et comprenant

        • une première ligne de réseau (5a) à laquelle sont associées la première phase (A) et une première traversée de condensateur (2a) et à laquelle est appliquée une première tension de réseau,
        • une deuxième ligne de réseau (5b) à laquelle sont associées la deuxième phase (B) et une deuxième traversée de condensateur (2b) et à laquelle est appliquée une deuxième tension de réseau,
        • une troisième ligne de réseau (5c) à laquelle sont associées la troisième phase (C) et une troisième traversée de condensateur (2c) et à laquelle est appliquée une troisième tension de ligne ;

    - chacune de ces traversées de condensateur (2a, 2b, 2c) comprenant

        • un conducteur (4) qui est connecté à la ligne de réseau associée (5a, 5b, 5c) ;
        • une armature électriquement conductrice (3) qui entoure ce conducteur (4) ;

    - à un premier instant prédéterminé (t1) pour chacune de ces phases (A, B, C)

        • un premier vecteur de tension de référence correspondant (Ra(t1), Rb(t1), Rc(t1)) étant déterminé pour une première tension de référence ;
        • une tension d'armature qui est appliquée entre l'armature respective (3) et le potentiel de masse (13), étant détectée et un premier vecteur de tension d'armature correspondant (Va(t1), Vb(t1), Vc(t1)) étant déterminé ;

    - à un deuxième instant prédéterminé (t2), qui est postérieur au premier instant (t1), pour chacune de ces phases (A, B, C)

        • un deuxième vecteur de tension de référence correspondant (Ra(t2), Rb(t2), Rc(t2)) étant déterminé pour une deuxième tension de référence ;
        • la tension d'armature étant détectée et un deuxième vecteur de tension d'armature correspondant (Va(t2), Vb(t2), Vc(t2)) étant déterminé ;

    **caractérisé en ce que**
    - pour chacune de ces traversées de condensateur (2a, 2b, 2c)

        • une variation de facteur de perte (ΔDa, ΔDb, ΔDc) est calculée en fonction des premier et deuxième vecteurs de tension de référence et vecteurs de tension d'armature respectifs et des premier et deuxième vecteurs de tension de référence et vecteurs de tension d'armature de la traversée de condensateur respectivement adjacente (2b, 2c, 2a),

    - la variation du facteur de perte de la première traversée de condensateur (2a) est calculée selon la formule suivante

$$\Delta D_a(t_2) = \theta_{ab}(t_2) - \theta_{ab}(t_1)$$

    avec

$$\theta_{ab}(t_j) = \left( \arccos \frac{\underline{V}_a(t_j) \cdot \underline{V}_b(t_j)}{\left|\underline{V}_a(t_j)\right| \cdot \left|\underline{V}_b(t_j)\right|} - \arccos \frac{\underline{R}_a(t_j) \cdot \underline{R}_b(t_j)}{\left|\underline{R}_a(t_j)\right| \cdot \left|\underline{R}_b(t_j)\right|} \right) , j = 1, 2 \quad ;$$

et/ou
- la variation du facteur de perte de la deuxième traversée de condensateur (2b) est calculée selon la formule suivante

$$\Delta D_b(t_2) = \theta_{bc}(t_2) - \theta_{bc}(t_1)$$

avec

$$\theta_{bc}(t_j) = \left( \arccos \frac{\underline{V}_b(t_j) \cdot \underline{V}_c(t_j)}{\left|\underline{V}_b(t_j)\right| \cdot \left|\underline{V}_c(t_j)\right|} - \arccos \frac{\underline{R}_b(t_j) \cdot \underline{R}_c(t_j)}{\left|\underline{R}_b(t_j)\right| \cdot \left|\underline{R}_c(t_j)\right|} \right) , j = 1, 2 \quad ;$$

et/ou
- la variation de facteur de perte de la troisième traversée de condensateur (2c) est calculée selon la formule suivante

$$\Delta D_c(t_2) = \theta_{ca}(t_2) - \theta_{ca}(t_1)$$

avec

$$\theta_{ca}(t_j) = \left( \arccos \frac{\underline{V}_c(t_j) \cdot \underline{V}_a(t_j)}{\left|\underline{V}_c(t_j)\right| \cdot \left|\underline{V}_a(t_j)\right|} - \arccos \frac{\underline{R}_c(t_j) \cdot \underline{R}_a(t_j)}{\left|\underline{R}_c(t_j)\right| \cdot \left|\underline{R}_a(t_j)\right|} \right) , j = 1, 2 \quad ;$$

- $\underline{R}a(t1)$, $\underline{R}b(t1)$, $\underline{R}c(t1)$ étant les premiers vecteurs de tension de référence des première, deuxième et troisième phases ;
- $\underline{V}a(t1)$, $\underline{V}b(t1)$, $\underline{V}c(t1)$ étant les premiers vecteurs de tension d'armature des première, deuxième et troisième phases ;
- $\underline{R}a(t2)$, $\underline{R}b(t2)$, $\underline{R}c(t2)$ étant les deuxièmes vecteurs de tension de référence des première, deuxième et troisième phases ;
- $\underline{V}a(t2)$, $\underline{V}b(t2)$, $\underline{V}c(t2)$ étant les deuxièmes vecteurs de tension d'armature des première, deuxième et troisième phases,

• la variation du facteur de perte étant comparée à une valeur de tolérance (DA, DB, DC) ;

- un signal de surveillance étant généré en fonction des résultats de ces comparaisons de facteurs de perte.

2. Procédé selon l'une des revendications précédentes,

- chaque tension de référence étant la tension de réseau respective (Ua(t1), Ua(t2), Ub(t1), Ub(t2), Uc(t1), Uc(t2)) .

3. Procédé selon la revendication 1,

- la première ligne de réseau (5a) étant associée à une traversée de condensateur parallèle (2a') ;
- la deuxième ligne de réseau (5b) étant associée à une deuxième traversée de condensateur parallèle (2b') ;

- la troisième ligne de réseau (5c) étant associée à une troisième traversée de condensateur parallèle (2c') ;
- chacune de ces traversées de condensateur parallèles (2a', 2b', 2c') comprenant

  • un conducteur (4) qui est relié à la ligne de réseau associée (5a, 5b, 5c),
  • une armature électriquement conductrice (3) qui entoure ce conducteur (4) ;

- pour chacune de ces phases (A, B, C)

  • les première et deuxième tensions de référence étant des première et deuxième tensions d'armature (Va' (t1), Vb' (t1), Vc'(t1), Va'(t2), Vb'(t2), Vc'(t2)), qui sont appliquées au premier instant et au deuxième instant entre l'armature (3) et le potentiel de masse (13) de la traversée de condensateur parallèle respective.

4. Procédé selon la revendication 1 ou l'une des revendications précédentes,

   - pour chacune de ces phases (A, B, C)

     • la tension de référence étant une tension constante pour laquelle un vecteur de tension constante correspondant est prédéterminé.

5. Procédé selon la revendication précédente,

   - l'intensité de chaque vecteur de tension constante étant égale à une valeur de tension nominale du réseau à courant alternatif ;
   - pour la première phase (A), l'angle de phase des premier et deuxième vecteurs de tension constante ($\underline{Ra}$(t1), $\underline{Ra}$(t2)) étant de 0° ;
   - pour la deuxième phase (B), l'angle de phase des premier et deuxième vecteurs de tension constante ($\underline{Rb}$(t1), $\underline{Rb}$(t2)) étant de 120° ;
   - pour la troisième phase (C), l'angle de phase des premier et deuxième vecteurs de tension constante ($\underline{Rc}$(t1), $\underline{Rc}$(t2)) étant de 240°.

6. Procédé selon l'une des revendications précédentes,

   - des valeurs de tolérance DA > 0, DB > 0, DC > 0 étant déterminées pour les comparaisons de facteur de perte ;
   - si les comparaisons des facteurs de perte montrent que l'on a

$$\left|\Delta D_a(t_2)\right| \le D_A \quad \text{et} \quad \left|\Delta D_b(t_2)\right| \le D_B \quad \text{et} \quad \left|\Delta D_c(t_2)\right| \le D_C \, ,$$

   alors un signal de surveillance étant généré qui indique que les traversées de condensateur (2a, 2b, 2c) sont en bon état.

7. Procédé selon l'une des revendications précédentes,

   - des valeurs de tolérance DA > 0, DB > 0, DC > 0 étant déterminées pour les comparaisons de facteurs de perte ;
   - si les comparaisons de facteurs de perte montrent que l'on a

$$\left|\Delta D_a(t_2)\right| > D_A \quad \text{et} \quad \left|\Delta D_b(t_2)\right| > D_B \quad \text{et} \quad \left|\Delta D_c(t_2)\right| \le D_C \, ,$$

   alors un signal de surveillance étant généré qui indique que la deuxième traversée de condensateur (2b) n'est pas en bon état ou que les deux autres traversées de condensateur (2a, 2c) ne sont pas en bon état et présentent un défaut similaire ;
   - si les comparaisons de facteurs de perte montrent que l'on a

$$\left|\Delta D_a(t_2)\right| \le D_A \quad \text{et} \quad \left|\Delta D_b(t_2)\right| > D_B \quad \text{et} \quad \left|\Delta D_c(t_2)\right| > D_C \, ,$$

alors un signal de surveillance étant généré qui indique que la troisième traversée de condensateur (2c) n'est pas en bon état, ou que les deux autres traversées de condensateur (2b, 2a) ne sont pas en bon état et présentent un défaut similaire ;
- si les comparaisons de facteurs de perte montrent que l'on a

$$\left|\Delta D_a(t_2)\right| > D_A \quad \text{et} \quad \left|\Delta D_b(t_2)\right| \le D_B \quad \text{et} \quad \left|\Delta D_c(t_2)\right| > D_C ,$$

alors un signal de surveillance étant généré qui indique que la première traversée de condensateur (2a) n'est pas en bon état ou que les deux autres traversées de condensateur (2c, 2b) ne sont pas en bon état et présentent un défaut similaire.

8. Procédé selon la revendication précédente,

- sinon, un signal de surveillance étant généré qui indique que les trois traversées de condensateur (2a, 2b, 2c) ne sont pas en bon état ou que deux traversées de condensateur ne sont pas en bon état et ne présentent pas de défaut similaire.

9. Procédé selon l'une des revendications précédentes,

- à un troisième instant prédéterminé (t3), qui est postérieur au deuxième instant (t2), pour chacune de ces phases (A, B, C)

  • un troisième vecteur de tension de référence correspondant (Ra(t3), Rb(t3), Rc(t3)) étant déterminé pour une tension de référence ;
  • la tension d'armature étant détectée et un troisième vecteur de tension d'armature correspondant (Va(t3), Vb(t3), Vc(t3)) étant déterminé ;
  • le deuxième vecteur de tension de référence étant remplacé par le troisième vecteur de tension de référence et le deuxième vecteur de tension d'armature étant remplacé par le troisième vecteur de tension d'armature ;

- pour chacune de ces traversées de condensateur (2a, 2b, 2c)

  • le calcul et la comparaison de la variation de facteur de perte (ΔDa, ΔDb, ΔDc) étant répétés ;

- un signal de surveillance étant généré en fonction des résultats de ces comparaisons de facteurs de perte.

10. Procédé selon la revendication précédente,

- avant chaque remplacement des deuxièmes vecteur de tension de référence et vecteur de tension d'armature,

  • le premier vecteur tension de référence étant remplacé par le deuxième vecteur de tension de référence et le premier vecteur de tension d'armature étant remplacé par le deuxième vecteur de tension d'armature.

11. Procédé selon l'une des revendications précédentes,

- au moins à un instant ultérieur prédéterminé (tn), qui est postérieur au deuxième instant (t2), pour chacune de ces phases (A, B, C)

  • un vecteur de tension de référence ultérieur correspondant (Ra(tn), Rb(tn), Rc(tn)) étant déterminé pour une tension de référence ;
  • la tension d'armature étant détectée et un vecteur de tension d'armature ultérieur correspondant (Va(tn), Vb(tn), Vc(tn)) étant déterminé ;

- pour chacune de ces traversées de condensateur (2a, 2b, 2c)

  • le calcul de la variation de facteur de perte (ΔDa, ΔDb, ΔDc) dépendant également des vecteurs tension de réseau et vecteurs de tension d'armature ultérieurs.

**12.** Procédé selon l'une des revendications précédentes,

- au moins à un instant ultérieur prédéterminé (tn), qui est postérieur au deuxième instant (t2), pour chacune de ces phases (A, B, C)

• un vecteur tension de référence ultérieur (Ra(tn), Rb(tn), Rc(tn)) étant déterminé ;
• la tension d'armature étant détectée et un vecteur de tension d'armature ultérieur correspondant (Va(tn), Vb(tn), Vc(tn)) étant déterminé ;

- pour chacune de ces traversées de condensateur (2a, 2b, 2c)

• une variation de facteur de perte ($\Delta$Da, $\Delta$Db, $\Delta$Dc) étant calculée en fonction des premiers et deuxièmes vecteurs de tension de référence et vecteurs de tension d'armature respectifs et les suivants ainsi que des premiers et deuxièmes vecteurs de tension de référence et vecteurs de tension d'armature et les suivants de la traversée de condensateur adjacente (2b, 2c, 2a) ;
• la variation de facteur de perte étant comparée à une valeur de tolérance (DA, DB, DC) ;

- un signal de surveillance étant généré en fonction des résultats de ces comparaisons de facteurs de perte.

**13.** Procédé selon l'une des 2 revendications précédentes,

- la variation de facteur de perte de la première traversée de condensateur (2a) étant calculée selon la formule suivante

$$\Delta D_a(t_n) = \sum_{i=2}^{n} \left\{ g_{ai} [\theta_{ab}(t_i) - \theta_{ab}(t_{i-1})] \right\}$$

avec

$$\theta_{ab}(t_j) = \arccos \frac{\underline{V}_a(t_j) \cdot \underline{V}_b(t_j)}{\left|\underline{V}_a(t_j)\right| \cdot \left|\underline{V}_b(t_j)\right|} - \arccos \frac{\underline{R}_a(t_j) \cdot \underline{R}_b(t_j)}{\left|\underline{R}_a(t_j)\right| \cdot \left|\underline{R}_b(t_j)\right|} \quad , j = 1, ..., n$$

$$\sum_{i=2}^{n} g_{ai} = 1 \qquad ;$$

et/ou
- la variation de facteur de perte de la deuxième traversée de condensateur (2b) étant calculée selon la formule suivante

$$\Delta D_b(t_n) = \sum_{i=2}^{n} \left\{ g_{bi} [\theta_{bc}(t_i) - \theta_{bc}(t_{i-1})] \right\}$$

avec

$$\theta_{bc}(t_j) = \arccos \frac{\underline{V}_b(t_j) \cdot \underline{V}_c(t_j)}{\left|\underline{V}_b(t_j)\right| \cdot \left|\underline{V}_c(t_j)\right|} - \arccos \frac{\underline{R}_b(t_j) \cdot \underline{R}_c(t_j)}{\left|\underline{R}_b(t_j)\right| \cdot \left|\underline{R}_c(t_j)\right|} \quad , j = 1, ..., n$$

$$\sum_{i=2}^{n} g_{bi} = 1 \quad ;$$

et/ou
- la variation de facteur de perte de la troisième traversée de condensateur (2c) étant calculée selon la formule suivante

$$\Delta D_c(t_n) = \sum_{i=2}^{n} \left\{ g_{ci}[\theta_{ca}(t_i) - \theta_{ca}(t_{i-1})] \right\}$$

avec

$$\theta_{ca}(t_j) = \arccos \frac{\underline{V}_c(t_j) \cdot \underline{V}_a(t_j)}{\left|\underline{V}_c(t_j)\right| \cdot \left|\underline{V}_a(t_j)\right|} - \arccos \frac{\underline{R}_c(t_j) \cdot \underline{R}_a(t_j)}{\left|\underline{R}_c(t_j)\right| \cdot \left|\underline{R}_a(t_j)\right|} \quad , j = 1, ..., n$$

$$\sum_{i=2}^{n} g_{ci} = 1$$

- n > 2 étant le nombre d'instants ;
- t1, t2 étant les premier et deuxième instants et t3, ..., tn étant les instants ultérieurs ;
- gai, gbi, gci étant les i-ièmes facteurs de pondération pour les première, deuxième et troisième traversées de condensateur.

14. Procédé selon la revendication précédente,

- chaque facteur de pondération dépendant de l'ancienneté de l'instant respectif de manière antitonale ; et/ou
- pour les facteurs de pondération

$$g_{ai-1} \leq g_{ai} \quad \text{et/ou} \quad g_{bi-1} \leq g_{bi} \quad \text{et/ou} \quad g_{ci-1} \leq g_{ci} \quad \text{pour i} = 2, ..., n$$

étant applicables.

15. Procédé selon l'une des revendications précédentes,

- entre la détermination du premier vecteur de tension de référence et la détermination du premier vecteur de tension d'armature

• les intensités des premiers vecteurs tension de référence étant comparées entre elles,
• la détermination du premier vecteur de tension d'armature étant effectuée si ces comparaisons d'intensités montrent que ces intensités ne diffèrent pas l'une de l'autre de plus d'une valeur prédéterminée ;

et/ou
- entre la détermination du deuxième vecteur de tension de référence et la détermination du deuxième vecteur de tension d'armature

• les intensités des deuxièmes vecteurs de tension de référence étant comparées entre elles,
• la détermination du deuxième vecteur de tension d'armature étant effectuée si ces comparaisons d'intensités montrent que ces intensités ne diffèrent pas l'une de l'autre de plus d'une valeur prédéterminée.

**16.** Procédé selon l'une des revendications précédentes,

- entre la détermination du premier vecteur de tension de référence et la détermination du premier vecteur de tension d'armature

• les angles de phase des premiers vecteurs de tension de référence étant comparés entre eux,
• la détermination des premiers vecteurs de tension d'armature étant effectuée si ces comparaisons d'angles montrent que ces angles de phase ne diffèrent pas l'un de l'autre de plus d'une valeur prédéterminée ;

- entre la détermination du deuxième vecteur de tension de référence et la détermination du deuxième vecteur de tension d'armature

• les angles de phase des deuxièmes vecteurs de tension de référence étant comparés entre eux,
• la détermination du deuxième vecteur de tension d'armature étant effectuée si ces comparaisons d'angles montrent que ces angles de phase ne diffèrent pas l'un de l'autre de plus d'une valeur prédéterminée.

**17.** Dispositif (1) de surveillance de traversées de condensateur (2a, 2b, 2c) destiné à un réseau à courant alternatif,

- le réseau à courant alternatif comportant des première, deuxième et troisième phases (A, B, C) et comprenant

• une première ligne de réseau (5a) à laquelle sont associées la première phase (A) et une première traversée de condensateur (2a) et à laquelle est appliquée une première tension de réseau,
• une deuxième ligne de réseau (5b) à laquelle sont associées la deuxième phase (B) et une deuxième traversée de condensateur (2b) et à laquelle est appliquée une deuxième tension de réseau,
• une troisième ligne de réseau (5c) à laquelle sont associées la troisième phase (C) et une troisième traversée de condensateur (2c) et à laquelle est appliquée une troisième tension de réseau ;

- chacune de ces traversées de condensateur (2a, 2b, 2c) comprenant

• un conducteur (4) qui est relié à la ligne de réseau associée (5a, 5b, 5c) ;
• une armature électriquement conductrice (3) entourant ce conducteur (4) ;

- le dispositif comprenant :

• un premier convertisseur de tension (9a) qui peut être relié à la première ligne de réseau (5a) ;
• un deuxième convertisseur de tension (9b) qui peut être relié à la deuxième ligne de réseau (5b) ;
• un troisième convertisseur de tension (9c) qui peut être relié à la troisième ligne de réseau (5c) ;
• un premier adaptateur de mesure (6a) qui peut être relié à l'armature (3) de la première traversée de condensateur (2a) ;
• un deuxième adaptateur de mesure (6b) qui peut être relié à l'armature (3) de la deuxième traversée de condensateur (2b) ;
• un troisième adaptateur de mesure (6c) qui peut être relié à l'armature (3) de la troisième traversée de condensateur (2c) ;
• une unité de mesure (7) qui est accouplée aux adaptateurs de mesure (6a, 6b, 6c) ;
• une unité d'évaluation (8) qui est accouplée aux convertisseurs de tension (9a, 9b, 9c) et à l'unité de mesure (7) ;

- chacun de ces convertisseurs de tension (9a, 9b, 9c) destiné à la phase respective (A, B, C) pouvant détecter la tension de réseau ;
- l'unité de mesure (7) destinée à chacune de ces phases (A, B, C) pouvant détecter une tension d'armature, qui est appliquée entre l'armature respective (3) et le potentiel de terre (13), à l'aide de l'adaptateur de mesure respectif (6a, 6b, 6c) ;
- l'unité d'évaluation (8) étant conçue de manière à ce qu'à un premier instant prédéterminé (t1) pour chacune de ces phases (A, B, C)

• le convertisseur de tension respectif (9a, 9b, 9c) soit utilisé pour détecter la tension de réseau et déterminer un premier vecteur de tension de réseau correspondant (Ua(t1), Ub(t1), Uct1)) ;
• l'unité de mesure (7) soit utilisée pour détecter la tension d'armature et déterminer un premier vecteur de tension d'armature correspondant (Va(t1), Vb(t1), Vc(t1)) ;

- l'unité d'évaluation (8) étant conçue de manière à ce qu'à un deuxième instant prédéterminé (t2), qui est postérieur au premier instant (t1), pour chacune de ces phases (A, B, C)

- le convertisseur de tension respectif (9a, 9b, 9c) soit utilisé pour détecter la tension de réseau et déterminer un deuxième vecteur de tension de réseau correspondant (Ua(t2), Ub(t2), Uc(t2)) ;
- l'unité de mesure (7) soit utilisée pour détecter la tension d'armature et déterminer un deuxième vecteur de tension d'armature correspondant (Va(t2), Vb(t2), Vc(t2)) ;

**caractérisé en ce que**
- l'unité d'évaluation (8) est conçue de manière à, pour chacune de ces traversées de condensateur (2a, 2b, 2c),

- pouvoir calculer une variation de facteur de perte (ΔDa, ΔDb, ΔDc) en fonction des premiers et deuxièmes vecteurs de tension de réseau et vecteurs de tension d'armature respectifs ainsi que des premiers et deuxièmes vecteurs de tension de réseau et vecteurs de tension d'armature de la traversée de condensateur respectivement adjacente (2b, 2c, 2a) ;
- pouvoir comparer la variation de facteur de perte à une valeur de tolérance (DA, DB, DC) ;

- l'unité d'évaluation (8) est conçue de manière à pouvoir générer un signal de surveillance en fonction des résultats de ces comparaisons de facteur de perte ; par lequel
- la variation de facteur de perte de la première traversée de condensateur (2a) est calculée selon la formule suivante

$$\Delta D_a(t_2) = \theta_{ab}(t_2) - \theta_{ab}(t_1)$$

avec

$$\theta_{ab}(t_j) = \left( \arccos \frac{V_a(t_j) \cdot V_b(t_j)}{|V_a(t_j)| \cdot |V_b(t_j)|} - \arccos \frac{R_a(t_j) \cdot R_b(t_j)}{|R_a(t_j)| \cdot |R_b(t_j)|} \right), j = 1, 2 \quad ;$$

et/ou
- la variation de facteur de perte de la deuxième traversée de condensateur (2b) est calculée selon la formule suivante

$$\Delta D_b(t_2) = \theta_{bc}(t_2) - \theta_{bc}(t_1)$$

avec

$$\theta_{bc}(t_j) = \left( \arccos \frac{V_b(t_j) \cdot V_c(t_j)}{|V_b(t_j)| \cdot |V_c(t_j)|} - \arccos \frac{R_b(t_j) \cdot R_c(t_j)}{|R_b(t_j)| \cdot |R_c(t_j)|} \right), j = 1, 2 \quad ;$$

et/ou
- la variation de facteur de perte de la troisième traversée de condensateur (2c) est calculée selon la formule suivante

$$\Delta D_c(t_2) = \theta_{ca}(t_2) - \theta_{ca}(t_1)$$

avec

$$\theta_{ca}(t_j) = \left( \arccos \frac{\underline{V}_c(t_j) \cdot \underline{V}_a(t_j)}{\left|\underline{V}_c(t_j)\right| \cdot \left|\underline{V}_a(t_j)\right|} - \arccos \frac{\underline{R}_c(t_j) \cdot \underline{R}_a(t_j)}{\left|\underline{R}_c(t_j)\right| \cdot \left|\underline{R}_a(t_j)\right|} \right), j = 1, 2 \quad ;$$

- Ra(t1), Rb(t1), Rc(t1) étant les premiers vecteurs de tension de référence des première, deuxième et troisième phases ;
- Va(t1), Vb(t1), Vc(t1) étant les premiers vecteurs d'armature des première, deuxième et troisième phases ;
- Ra(t2), Rb(t2), Rc(t2) étant les deuxièmes vecteurs de tension de référence des première, deuxième et troisième phases ;
- Va(t2), Vb(t2), Vc(t2) étant les deuxièmes vecteurs de tension d'armature des première, deuxième et troisième phases.

FIG. 1

EP 3 589 964 B1

**FIG. 2**

EP 3 589 964 B1

## FIG. 3

**FIG. 4**

FIG. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004027349 A1
- DE 10037432 A1
- WO 2015071253 A1